# EUROPÄISCHE PATENTSCHRIFT

(11) **EP 0 866 500 B1**
(45) Veröffentlichungstag und Bekanntmachung des Hinweises auf die Patenterteilung: **26.04.2006**
(21) Anmeldenummer: 98102060.5
(22) Anmeldetag: 06.02.1998
(51) Int. Cl.: H01L 23/373, F28F 3/08, H01L 23/473, H01L 23/467

(54) **Kühler bzw. Wärmesenke für elektrische Bauelemente oder Schaltkreise sowie elektrischer Schaltkreis mit einer solchen Wärmesenke**
Cooling apparatus or heat sink for electrical devices or circuits and electrical circuit with such a heat sink
Refroidisseur ou dissipateur de chaleur pour composants ou circuits électriques et circuit électrique utilisant ce dissipateur de chaleur

(30) Priorität: 17.03.1997 DE 19710783
(43) Veröffentlichungstag der Anmeldung: 23.09.1998
(73) Patentinhaber: Curamik Electronics GmbH, 92676 Eschenbach (DE)
(72) Erfinder: Schulz-Harder, Jürgen, Dr., 91207 Lauf (DE); Exel, Karl, Dr., 64668 Rimbach/odw (DE); Medick, Bernd, Dipl.-Ing.(FH), 95632 Wunsiedel (DE); Bauer-Schulz-Harder, Veronika, 91207 Lauf (DE)
(74) Vertreter: Graf, Helmut

(56) Entgegenhaltungen:
- EP-A- 0 194 216
- EP-A- 0 471 552
- WO-A-95/23951
- US-A- 4 420 739
- US-A- 4 624 305
- US-A- 5 193 611
- US-A- 5 423 376
- "FOAM ENHANCED HEAT SINK" IBM TECHNICAL DISCLOSURE BULLETIN, Bd. 39, Nr. 4, 1. April 1996, Seite 101/102 XP000587436

## Beschreibung

Die Erfindung bezieht sich auf einen Kühler gemäß Oberbegriff Patentanspruch 1 sowie auf einen elektrischen Schaltkreis entsprechend Patentanspruch 21.

Wärmesenken für elektrische Bauelemente, insbesondere auch Wärmesenken, die aus einer Vielzahl von stapelartig übereinander angeordneten Schichten oder Lagen bestehen, sind grundsätzlich bekannt. Bekannt ist hierbei auch die Verwendung von Metall-Lagen, die mittels des sogenannten "DCB-Verfahrens" (Direct-Copper-Bond-Technology) miteinander verbunden sind.

Bekannt ist speziell auch eine Kühler- oder Wärmesenke zum Kühlen von elektrischen Bauelementen oder Schaltkreisen (EP-A-0 194 216), bei der zwischen zwei die Oberseite bzw. Unterseite der Wärmesenke bildenden Platten eine Vielzahl weiterer, jeweils eine Kühlerlage bildende Platten mit Durchbrüchen so vorgesehen sind, dass bei stapelartig übereinander angeordneten Kühlerlagen sich die einzelnen Durchbrechungen sowie um die Durchbrechungen verbliebene Materialabschnitte von Kühlerlage zu Kühlerlage überlappen und sich somit mehrere parallele streifenförmige Strömungswege ergeben, die sich jeweils mehrfach in der Richtung ändern.

Bekannt ist ein femer Wärmetauscher (US-A-5 193 611), der aus vier flächig miteinander verbundenen Platten besteht und in seinem Inneren von einem wärmetransportierenden Medium durchströmbare Kanäle aufweist, die dadurch gebildet sind, dass die beiden inneren, zwei Kühllagen bildenden Platten mit einer Vielzahl von Durchbrüchen versehen sind.

Aufgabe der Erfindung ist es, einen Kühler bzw. eine Wärmesenke für elektrische Bauelemente oder Schaltkreise aufzuzeigen, der bzw, die bei vereinfachter Herstellbarkeit eine verbesserte Kühlleistung aufweist.

Zur Lösung dieser Aufgabe ist ein Kühler entsprechend dem Patentanspruch 1 ausgebildet. Ein elektrischer Schaltkreis ist entsprechend dem Patentanspruch 21 ausgeführt.

Bei der Erfindung sind die vom Kühlmedium im Inneren des Kühlers durchströmten Kanäle dadurch gebildet, daß die einzelnen Kühlertagen einen siebartig strukturierten Bereich aufweisen, der eine Vielzahl von Öffnungen mit jeweils geschlossener Randlinie und mit zwischen diesen Öffnungen verbleibenden Materialstegen oder Materialbereichen besitzt. Keine dieser Öffnungen in keiner Kühlertage bildet einen durchgehenden, von einem Sammelraum zum Zuführen des Kühlmediums an einem Sammelraum zum Abführen des Kühlmediums reichenden Kanal. Die einzelnen Durchbrechungen und die zwischen diesen vorgesehenen Materialstege oder Materialbereiche sind vielmehr von Kühlerlage zu Kühlerlage derart versetzt vorgesehen, daß ein Durchströmen des Kühlers von dem Kühlmedium nur unter ständigem Wechsel der Lagen und unter Nutzung der Durchbrechungen möglich ist, sich also im Inneren des Kühlers ein von dem Kühlmedium durchströmbares, sehr verzweigtes Labyrinth ergibt, in welchem in den von den Durchbrechungen gebildeten Strömungswegen jeweils die den Durchbrechungen gegenüberliegenden Materialabschnitte vorgesehen sind. Die Größe der Durchbrechungen und die Breite der Materialabschnitte bzw. Materialstege sind so aufeinander abgestimmt, daß das Durchströmen unter ständigen Wechsel der Lagen möglich ist.

Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in vereinfachter Darstellung und im Schnitt einen aus einer Vielzahl von stapelartig übereinander angeordneten und jeweils von einer Metallfolie gebildeten Lagen hergestellten Kühler (Wärmesenke) gemäß der Erfindung;
- Fig. 2 und 3: jeweils in Einzeldarstellung und in Draufsicht zwei im Stapel aufeinander folgende Kühlerlagen N1 und N2 bei einer ersten möglichen Ausführungsform der Erfindung;
- Fig. 4: eine Draufsicht auf die beiden im Kühler übereinander angeordneten Lagen der Figur 2;
- Fig. 5 und 6: in vergrößerter Teildarsteltung die Kühlerlagen der Figuren 2 und 3 jeweils im Bereich einer Mittelachse M;
- Fig. 7: eine vergrößerte Detaildarstellung der Figur 4;
- Fig. 8: in vergrößerter Darstellung einen Teilschnitt durch den Kühler entsprechend der Linie 1 - 1 der Figur 7;
- Fig. 9-11: änliche Darstellungen wie die Figuren 2 - 4 bei einer weiteren, abgewandelten Ausführungsform;
- Fig. 12 und 13: Darstellungen ähnlich den Figuren 5 und 6 bei der Ausführungsform der Figuren 9 - 1 1;
- Fig. 14 - 16: ähnliche Darstellungen wie die Figuren 2 - 4, allerdings bei einer weiteren möglichen Ausführungsform des erfindungsgemäßen Kühlers;
- Fig. 17: eine vergrößerte Detaildarstellung der Figur 14;
- Fig. 18: eine vergrößerte Detaildarstellung der Figur 16;
- Fig. 19: eine vergrößerte Detaildarstellung der Figur 16;
- Fig. 20: einen Teilschnitt durch den Kühler der Figuren 14 - 19 entsprechend der Linie II - II der Figur 19;
- Fig. 21: in einer Darstellung änlich Figur 1 eine weitere, mögliche Ausführungsform des erfindungsgemäßen Kühlers, bei dem zwei Einzelkühler in Kaskade aufeinander folgend vorgesehen sind;
- Fig. 22: in vereinfachter Darstellung den Zuschnitt einer der beiden Einzelkühler trennenden Zwischen- oder Trennlage;
- Fig. 23: prinzipiell die Ausbildung der Kühlerlagen bei an einer gemeinsamen Seite des Kühlers herausgeführten Anschlüssen;
- Fig. 24: ein als Verdampfungskühler ausgebildeter Kühler gemäß der Erfindung;
- Fig. 25: ein Diagramm, welches die Wirkung des erfindungsgemäßen Kühlers wiedergibt.

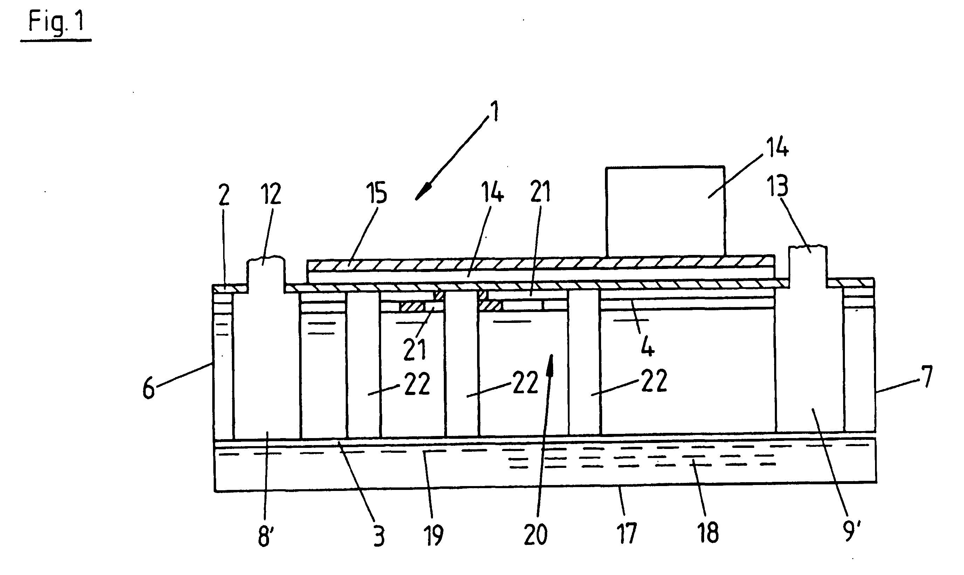

In der Figur 1 ist in vereinfachter Darstellung und im Schnitt ein Kühler 1 dargestellt, der aus einer Vielzahl von dünnen Lagen besteht, die stapelartig übereinander angeordnet und miteinander verbunden sind, und zwar aus einer oberen und einer unteren Abschlußlage 2 bzw. 3 und aus einer Vielzahl zwischen diesen angeordneten Kühlerlagen, die in der Figur 1 allgemein mit 4 bezeichnet sind, aber tatsächlich das nachstehend noch näher beschriebene, unterschiedliche Layout aufweisen. Der quaderförmig ausgebildete Kühler 1 besitzt in Draufsicht eine quadratische Umfangsfläche.

Bei der dargestellten Ausführungsform sind die Lagen 2 - 4 von dünnen Platten oder Folien aus Metall, beispielsweise aus Kupfer gebildet, die z.B. mit Hilfe der DCB-Technik flächig miteinander zum Kühler 1 verbunden sind. Grundsätzlich sind selbstverständlich auch andere Methoden denkbar, um die einzelnen Lagen 2 - 4 zu dem Kühler flächig miteinander zuverbinden, beispielsweise durch Diffusions-Bonden, bei dem die Lagen 2 - 4 unter hohem Druck und unter Hitzeeinwirkung an ihren Grenzflächen verschweißen.

Die Kühlerlagen 4 sind generell so strukturiert, daß sie jeweils im Bereich zweier einander gegenüberliegender Seiten 6 bzw. 7 eine Öffnung 8 bzw. 9 aufweisen, die zu diesen Seiten 6 bzw. 7 und den rechtwinklig anschließenden Umfangsseiten 10 und 11 der jeweiligen Kühlerlage 4 geschlossen sind und beispielsweise bei den in den Figuren dargestellten Ausführungsformen jeweils als gleichseitiges, stumpfes Dreieck (als Dreieck mit einem Winkel wesentlich größer als 90° zwischen den beiden gleichen Seiten) ausgeführt sind. Die einzelnen Kühlerlagen 4 sind mit ihren Öffnungen 8 und 9 deckungsgleich angeordnet, so daß die Öffnung 8 einen Sammelraum 8' zum Zuführen eines Kühlmediums und die Öffnungen 9 einen Sammelraum 9' zum Abführen des Kühlmediums bilden. An der oberen Abschlußlage 3 sind für die Sammelräume 8' und 9' Anschlüsse 12 und 13 vorgesehen, von denen der Anschluß 12 an einem Kühlmediumvorlauf und der Anschluß 13 an einem Kühlmediumrücklauf anschließbar ist.

Bei dem Kühler 1 der Figur 1 ist auf der dem Kühlerlagen 4 abgewandten Oberseite der Abschlußlage 2 eine Keramikschicht 14 befestigt, auf der dann eine weitere strukturierte Metallschicht 15 vorgesehen ist. Letztere ist beispielsweise von einer Metallfolie gebildet, die mit Hilfe üblicher Techniken strukturiert wurde, um so das jeweils gewünschte Layout für elektrische Leiterbahnen, Kontaktflächen usw. zu erhalten. Die die Metallisierung 15 bildende Metallfolie ist beispielsweise eine Kupferfolie. Die Keramikschicht 14 und die die Metallisierung 15 bildende Metallschicht sind beispielsweise unter Verwendung der DCB-Technik mit dem Kühler 1 sowie miteinander verbunden.

Mit 16 sind elektrische Bauelemente bezeichnet, die auf der Metallisierung 15 bzw. auf von dieser gebildeten Kontaktflächen in geeigneter Weise befestigt sind. Grundsätzlich besteht insbesondere bei Bauelementen 16 mit extrem hoher Leistung auch die Möglichkeit, diese unmittelbar an der oberen Abschlußlage 2 zu befestigen, sofern dies das jeweilige Bauelement 16 zuläßt.

Die Keramikschicht 14 ist beispielsweise eine solche aus einer Aluminiumoxid-Keramik. Grundsätzlich ist es aber auch möglich, daß die Keramikschicht 14 zumindest in Teilbereichen aus einer Aluminiumnitrid-Keramik besteht, und zwar insbesondere dann, wenn zur Erzielung einer möglichst großen Kühlwirkung ein möglichst geringer thermischer Widerstand notwendig ist.

Die an der unteren Abschlußlage 3 gebildete Unterseite des Kühlkörpers 1 ist bei der Figur 1 mit einem Tragelement 17 aus Metall verbunden. Dieses Tragelement 17 ist beispielsweise eine Platte, kann aber auch mit Kanälen ausgeführt sein, die in der Figur 1 mit unterbrochenen Linien 18 angedeutet sind und die zum Zuführen und Abführen des Kühlmediums dienen und hierfür jeweils mit einem Sammelraum 8' bzw. 9' in Verbindung stehen. Die Anschlüsse 12 und 13 entfallen dann oder sind verschlossen. Mit Hilfe der Kanäle 18 ist beispielsweise ein seitliches Anschließen des Kühlers 1 an den Kühlmediumvorlauf bzw. Kühlmediumrücklauf möglich. Weist der Träger 17 die Kanäle 18 auf, ist dieser Träger beispielsweise ebenfalls aus einer Vielzahl von miteinander verbundenen Lagen beispielsweise aus Metall gebildet, wobei jede Lage dann wenigstens zwei schlitzartige Ausnehmungen aufweist und die jeweils gleichen Ausnehmungen jeder Lage deckungsgleich miteinander angeordnet sind, so daß die Kanäle 18 zum Zuführen bzw. Abführen des Kühlmediums gebildet sind.

In der Figur 1 ist weiterhin mit 19 eine Isolierschicht oder Keramikschicht an der unteren Abschlußlage 3 angedeutet. Diese weitere Keramikschicht 19, die beispielsweise von einer Aluminiumoxid-Keramik gebildet ist, wird z.B. dann verwendet, wenn eine isolierte Befestigung des Kühlers 1 z.B. auf einer den Träger 17 bildenden Platte erforderlich ist. Die Keramikschicht 19 ist beispielsweise wiederum mit Hilfe der DCB-Technik mit dem Kühler 1 und/oder mit dem Tragelement 17 verbunden. Es besteht weiterhin auch die Möglichkeit, die obere und/oder untere Abschlußlage 2 bzw. 3 jeweils als Keramikschicht auszuführen, wobei dann die Keramikschichten 14 und 19 weggelassen werden können.

Allen nachstehend näher beschriebenen Ausführungsformen ist gemeinsam, daß die Kühlerlagen 4 zwischen den beiden Öffnungen 8 und 9 einen eine Vielzahl von Durchbrechungen 21 aufweisenden siebartig strukturierten Bereich besitzen, der in der Figur 1 allgemein mit 20 bezeichnet ist. Dieser Bereich 20 und die beidseitig von diesem vorgesehenen Öffnungen 8 und 9 jeder Kühlerlage 4 befinden sich innerhalb eines geschlossenen Randbereichs dieser Kühlerlage. Die Bereiche 20 sind mit den Durchbrechungen und mit den zwischen diesen verbliebenen netzartigen Materialstegen oder -bereichen derart ausgebildet, daß die stapelartig aneinander anschließenden Kühlerlagen 4 mit bestimmten, von Kühlerlage zu Kühlerlage immer wieder, d.h durchgehend aneinander anliegenden und miteinander verbundenen Teilbereichen der Materialstege bzw. -abschnitte durchgehende Säulen 22 bilden, die mit ihrer Längserstreckung senkrecht zu den Ebenen der Lagen 2 - 4 liegen und von der oberen Abschlußlage 2 bis an die untere Abschlußlage 3 reichen. Jede Durchbrechung 21 in einer Kühlerlage 4 überlappt in einer Blickrichtung senkrecht zu den Ebenen der Lagen 2 - 4 wenigstens eine Durchbrechung 21 einer benachbarten Kühlerlage nur teilweise, so daß jeder Durchbrechung 21 einer Kühlerlage 4 auch wenigstens ein weiterer Teilbereich mindestens eines Materialsteges oder eines Materialabschnittes einer benachbarten Kühlerlage gegenüberliegt. Hierdurch sind zwischen den Säulen 22 vielfach abgewinkelte und die Lagen ständig wechselnde Strömungswege für das Kühlmedium gebildet, welches dann ebenfalls nur unter ständigem Wechseln der Ebenen, zumindest unter ständigem Wechseln der Ebenen zweier benachbarter Kühlerlagen 4 von dem Sammelraum 8' an dem Sammelraum 9' gelangen kann. Hierbei werden die Säulen 22, die jeweils auch in der Achsrichtung zwischen den Sammelräumen 8' und 9' mehrfach aufeinander folgend und von einander beabstandet vorgesehen sind, jeweils allseitig intensiv umströmt, aber auch die Materialstege oder Materialabschnitte der Kühlerlagen 4 seitlich von diesen Säulen, womit eine besonders intensive Kühlwirkung bzw. ein besonders hoher Wirkungsgrad erzielt wird.

Vorstehend wurde davon ausgegangen, daß sich im Kühler 1 jeweils Kühlerlagen 4 mit der angegebenen Struktur aneinander anschließen. Grundsätzlich besteht natürlich auch die Möglichkeit, daß jede Kühlerlage 4 oder aber einzelne Kühlerlagen 4 von mehreren Schichten gebildet sind.

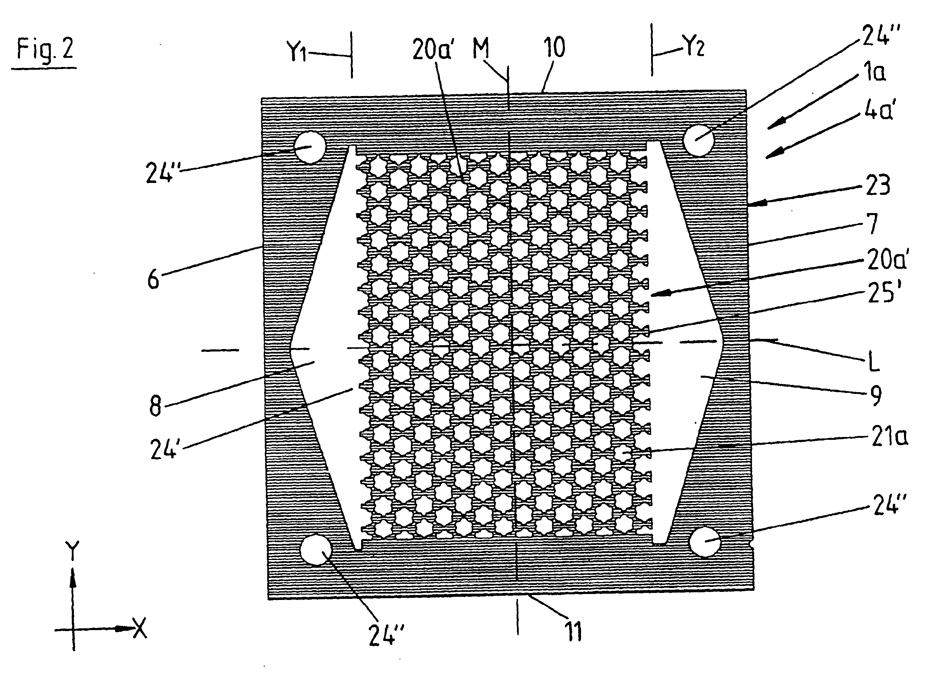

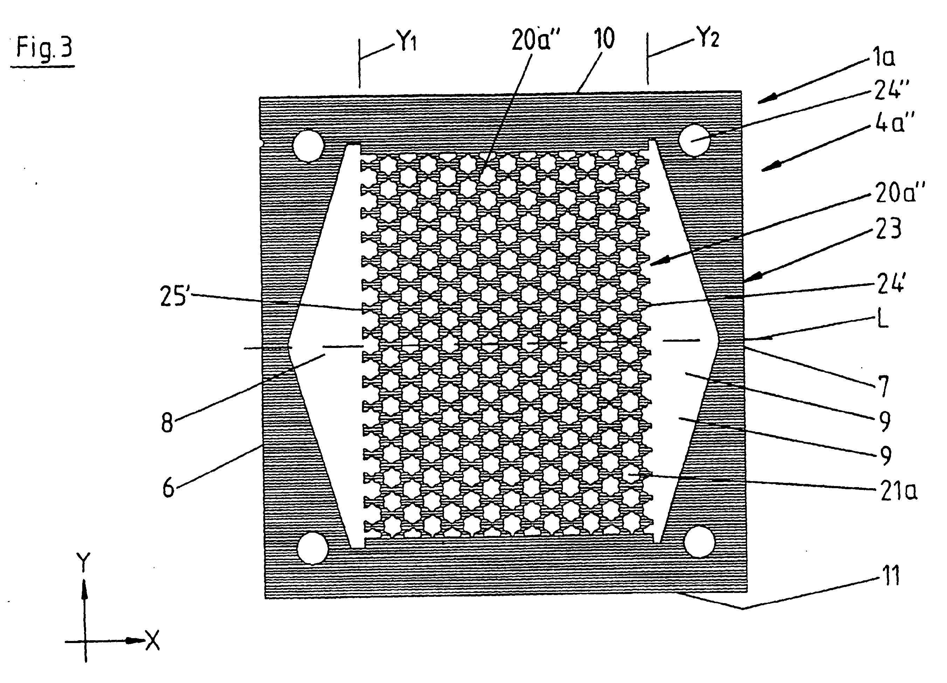

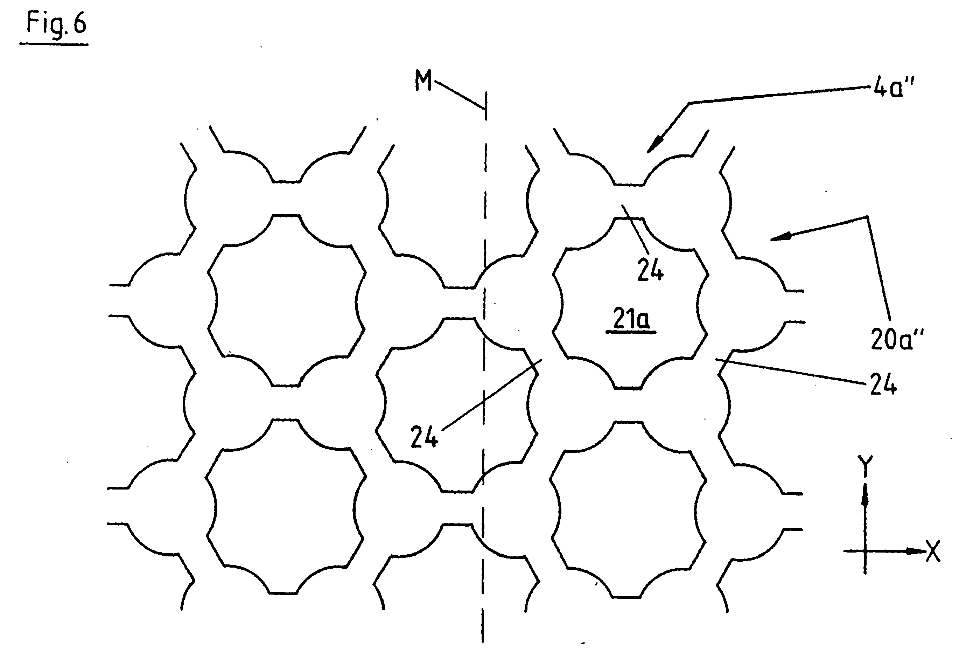

Die Figuren 2 - 8 erläutern im Detail eine mögliche Ausgestaltung der Kühlerlagen 4 des Kühlers 1a. Diese Kühlerlagen sind in den Figuren 2 - 8 mit 4a' und 4a" bezeichnet, wobei in dem den Kühler 1 a bildenden Stapel jeweils eine Kühlerlage 4a' einer Kühlerlage 4a" unmittelbar benachbart liegt und umgekehrt. Wie nachstehend noch näher beschrieben wird, sind die Kühlerlagen 4a' und 4a" hinsichtlich des strukturierten Bereichs 20a' bzw. 20a" so ausgebildet, daß ein Wenden bzw. Umdrehen der Kühlerlage 4a' um eine in der Mitte zwischen den beiden Umfangsseiten 6 und 7 und parallel zu diesen Umfangsseiten verlaufende Mittelachse M die Kühlerlage 4a" ergibt.

Es wird daher nachstehend zunächst die Kühlerlage 4a' beschrieben. Diese besteht aus einem quadratischen Zuschnitt aus der Metallfolie, nämlich z.B. der Kupferfolie. Der Zuschnitt 23 bildet die Umfangsseiten 6, 7 und 10 sowie 11, die jeweils rechtwinklig aneinander anschließen und von denen sich die Umfangsseiten 6 und 7 sowie 10 und 11 parallel zueinander verlaufend gegenüberliegen. In den Eckbereichen des Zuschnittes 23 ist jeweils eine Bohrung 24" vorgesehen. Die Mittelpunkte der Bohrungen 24" bilden die Eckpunkte eines gedachten Quadrates, welches mit seinen Seiten parallel zu den Seiten 6, 7, 10 und 11 liegt. Wie insbesondere die Figur 2 zeigt, ist die Kühlerlage 4a' hinsichtlich der Öffnung 8 und 9, der Strukturierung des Bereiches 20 und der Bohrungen 24" symmetrisch zu einer Längsachse L ausgebildet, die parallel zu den Umfangsseiten 10 und 11 sowie senkrecht zu den Umfangsseiten 6 und 7 und damit auch senkrecht zu der Mittelachse M verläuft. Weiterhin ist die Kühlerlage 4a' hinsichtlich der Bohrungen 24" sowie im wesentlichen auch hinsichtlich der Öffnungen 8 und 9 symmetrisch zu der Mittelachse M ausgebildet. Der Bereich 20a' besteht aus einer Vielzahl von Durchbrechungen, die in den Figuren 2 - 8 mit 21 a bezeichnet sind, sowie aus einer Vielzahl von stegartigen Materialabschnitten 24, die ein hexagonales Gitterwerk mit einer Vielzahl von hexagonalen bzw. sechseckförmigen Ringstrukturen, die unmittelbar aneinander anschließen und bei denen die Eckpunkte jeweils von runden bzw. kreisscheibenartigen Teilbereichen oder Inseln 25 mit einer im Vergleich zu den Stegen 24 vergrößerten Breite gebildet sind. Durch die hexagonalen Ringstrukturen bedingt, bildet jede Insel 25 einen Knoten; von welchem insgesamt drei Materialstege 24 ausgehen. Jede Durchbrechung 21 a ist von einer Ringstruktur umschlossen. Die Mittelpunkte der Inseln 25 bilden demnach Eckpunkte von aneinander anschließenden Sechsecken mit jeweils gleicher Seitenlänge. Weiterhin bilden die Verbindungslinien zwischen den Mittelpunkten der Inseln 25 die Längserstreckung der Materialstege 24.

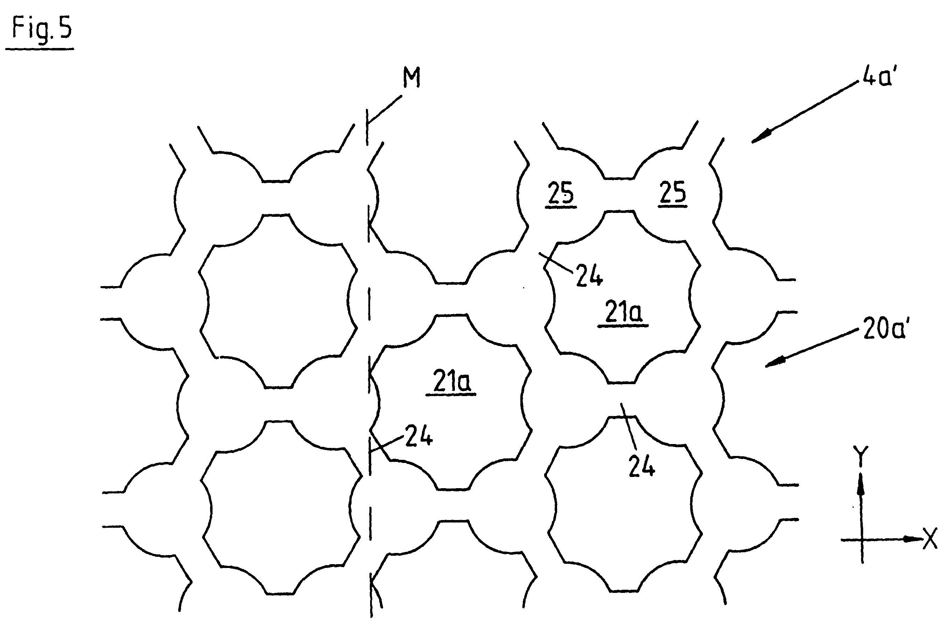

Zur einfacheren Orientierung sind in den Figuren zwei rechtwinklig zueinander verlaufende Koordinatenachsen, nämlich die X-Achse und Y-Achse eingezeichnet, von denen die X-Achse parallel zur Längsachse L und damit parallel zu den Umfangsseiten 10 und 11 und die Y-Achse parallel zur Mittelachse M und damit parallel zu den Umfangsseiten 6 und 7 liegt. Wie speziell in der Figur 5 wiedergegeben ist, sind die von den Stegen 24 und Inseln 25 gebildeten Ringstrukturen so orientiert, daß jeweils zwei parallel zueinander angeordnete Umfangsseiten jedes Sechsecks, d.h. zwei parallel zueinander verlaufende Materialstege 24 jeder hexagonalen Ringstruktur mit ihrer Längserstreckung in der X-Achse liegen und diese beiden Materialstege in Richtung der Y-Achse gegeneinander versetzt sind. Die übrigen vier Materialstege 24 jeder vollständigen Ringstruktur schließen mit der X-Achse und der Y-Achse jeweils einen Winkel von 60° ein. Wie die Figuren auch zeigen, besitzen die Inseln 25 einen Durchmesser, der kleiner ist als der Durchmesser der jeweiligen Durchbrechung 21 a.

Wie die Figur 2 zeigt, endet der Bereich 20a' an den Öffnungen 8 und 9 jeweils mit unvollständigen Ringstrukturen, und zwar an der Öffnung 8 jeweils mit einer halben Ringstruktur in der Weise, daß dort von Inseln 25 jeweils in Richtung der X-Achse Materialstege 24 mit halber Länge wegstehen und bei 24' enden. An der Öffnung 9 endet der Bereich 20a' mit unvollständigen Ringstrukturen in der Weise, daß sich an Inseln 25 in Richtung der X-Achse erstreckende Materialabschnitte 24 anschließen, von denen jeder in einer halben Insel 25 bei 25' endet.

Wie die Figur 2 weiterhin zeigt, liegen die Enden 24' im Bereich der Öffnung 8 auf einer gemeinsamen, in Richtung der X-Achse verlaufenden Linie Y1. Ebenso liegen die Enden 25' an der Öffnung 9 auf einer gemeinsamen, in Richtung der Y-Achse verlaufenden Linie Y2. Der Abstand, den die Linie Y1 in Richtung der X-Achse von der Umfangsseite 6 und von dem Mittelpunkt der dieser Umfangsseite benachbarten Bohrungen 24" aufweist, ist gleich dem Abstand, den die Linie Y2 von der Umfangsseite 7 und dem Mittelpunkt der dieser Umfangsseite benachbarten Bohrungen 24" aufweist.

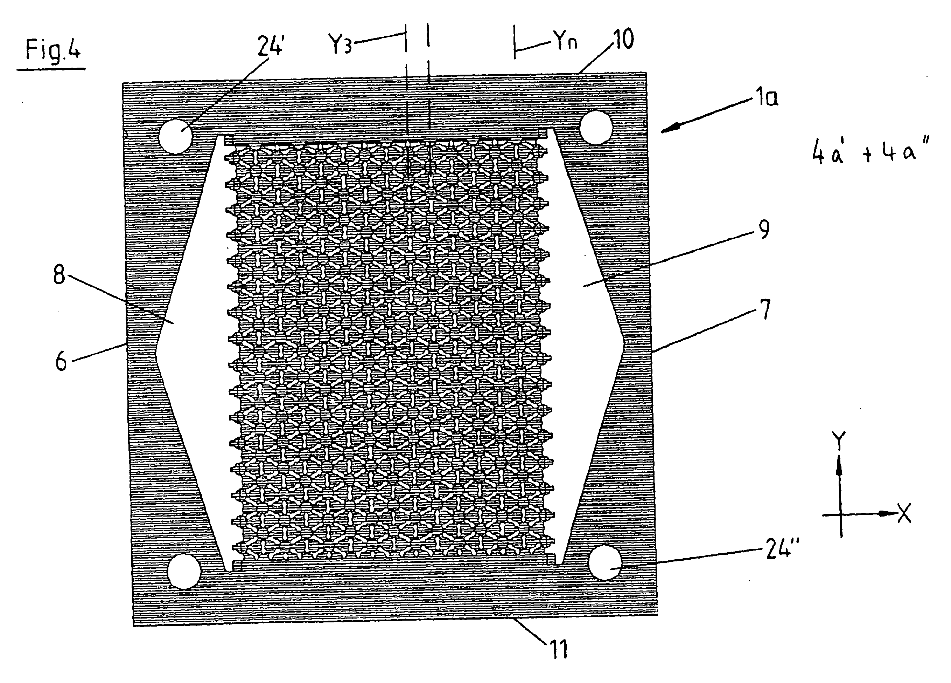

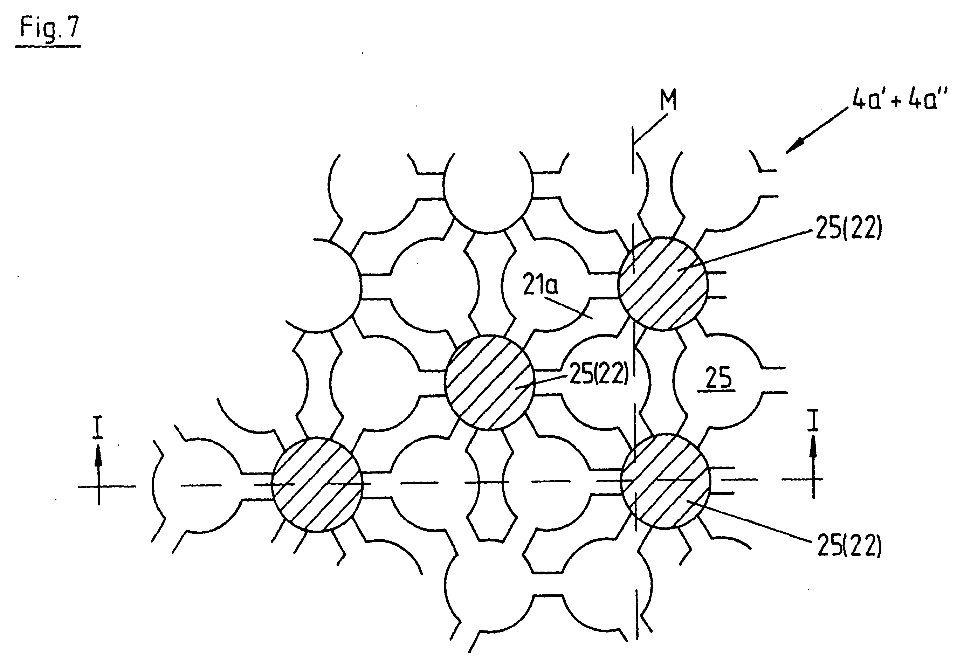

Wie oben bereits aufgeführt wurde, ist die Kühlerlage 4a" indentisch mit der um die Mittelachse M um 180° gewendeten Kühlerlage 4a' ausgebildet, d.h. bei der Kühlerlage 4a" befinden sich an dem Bereich 20a" die Enden 25' innerhalb der Öffnung 8 auf der Linie Y1 und die Enden 24' innerhalb der Öffnung 9 auf der Linie Y2. Durch die beschriebene Ausbildung der Bereiche 20a' und 20a" der Kühlerlagen 4a' und 4a" ergibt sich, daß bei der Kühlerlage 4a" die hexagonalen Ringstrukturen in Richtung der X-Achse um einen Betrag versetzt sind, der gleich dem Abstand der Mittelpunkte zweier auf einer gemeinsamen X-Achse liegender und in Richtung dieser Achse aufeinander folgender Inseln 25 ist. Werden nun die Kühlerlagen 4a' und 4a" abwechseln aufeinandergelegt, so ergibt sich entsprechend den Figuren 4 und 7, daß jeweils bei allen Lagen einzelne Inseln 25 in Richtung senkrecht zu den Ebenen dieser Lage deckungsgleich angeordnet sind und damit die durchgehenden Säulen 22 bilden, während andere Inseln 25 in der jeweiligen Kühlerlage 4a' bzw. 4a" jeweils einer Durchbrechung 21a einer benachbarten Kühlerlage 4a" bzw. 4a' gegenüberliegt.

Die durchgehenden Säulen 22 sind jeweils in einer dreieckförmigen Struktur vorgesehen, d.h. die Schnittpunkte der Achsen dieser Säulen 22 mit einer gedachten Ebene parallel zu den Lagen 4a' oder 4a" bilden jeweils die Eckpunkte von Dreiecken, und zwar derart, daß jeweils mehrere dieser Schnittpunkte auf Linien Y3, Y4 ... Yn liegen, die parallel zur Y-Achse verlaufen und in Richtung der X-Achse um den gleichen Betrag gegeneinander versetzt sind, wobei die Schnittpunkte auf jeder Linie gegenüber den Schnittpunkten auf einer benachbarten Linie mittig auf Lücke versetzt sind.

Die Dicke der Kühlerlagen 4a' und 4a" liegt beispielsweise in der Größenordnung von 0,2 bis 1,0 mm. Der Mittel- oder Rasterabstand den die in Richtung der X-Achse verlaufenden Materialstege 24 in Richtung der Y-Achse voneinander aufweisen beträgt beispielsweise 1,0 bis 10,0 mm. Die Breite der Materialstege 24 liegt z.B. in der Größenordnung von etwa 5 bis 25% des vorgenannen Rasterabstandes. Der Radius der Inseln 25 ist maximal gleich dem halben Abstand, den zwei Eckpunkte des jeweiligen Sechsecks voneinander aufweisen, d.h. der Durchmesser jeder Insel 25 ist maximal gleich diesem Abstand bzw. der Seitenlänge der Sechsecke.

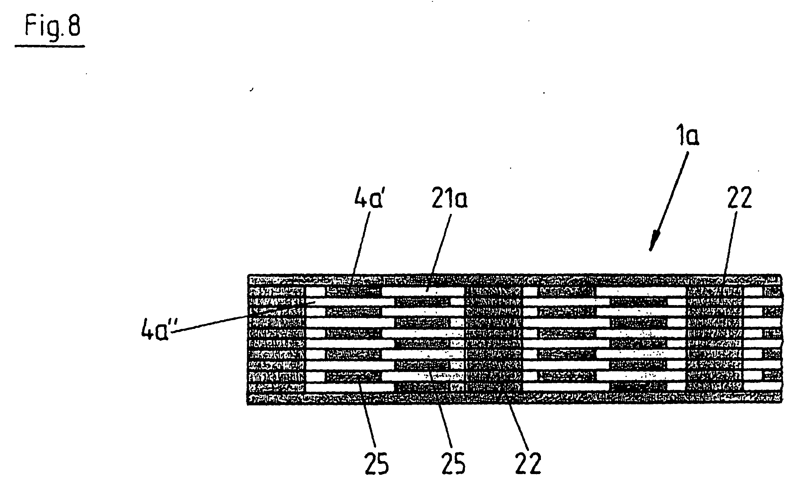

Die Figur 8 zeigt einen Schnitt entsprechend der Linie 1 - 1 der Figur 7. Aus diesem Schnitt ist nochmals deutlich ersichtlich, daß entlang der Schnittlinie, die in Richtung der X-Achse verläuft, jeweils zwischen zwei Säulen 22 Durchbrechungen in den Kühlerlagen 4a' und 4a" gebildet sind, und zwar derart, daß jeweils innerhalb dieser Durchbrechungen eine Insel 25 einer Kühlerlage der Durchbrechung 21a einer benachbarten Kühlerlage gegenüberliegt.

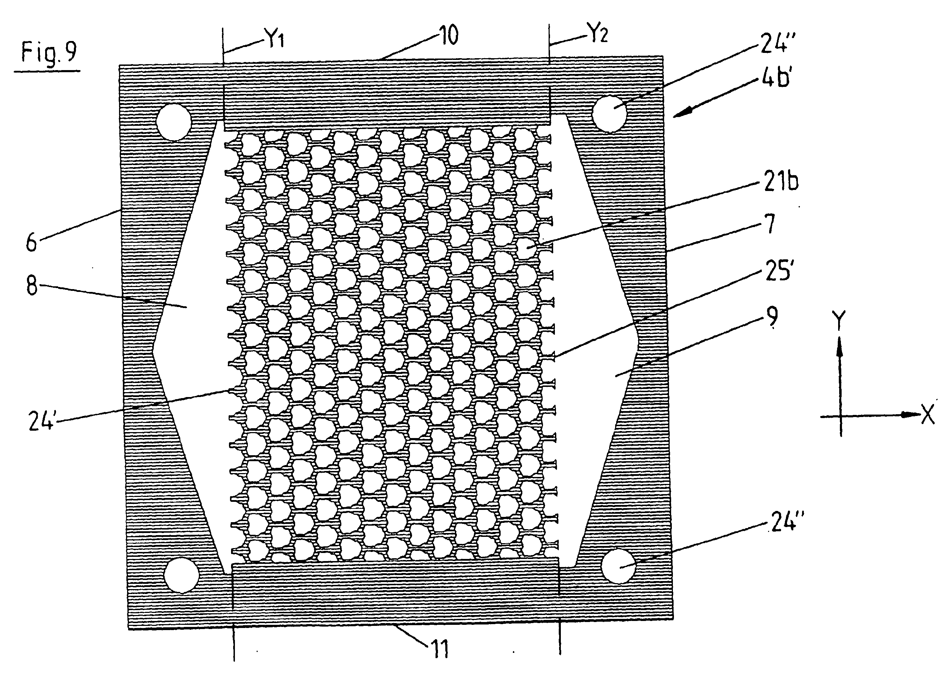

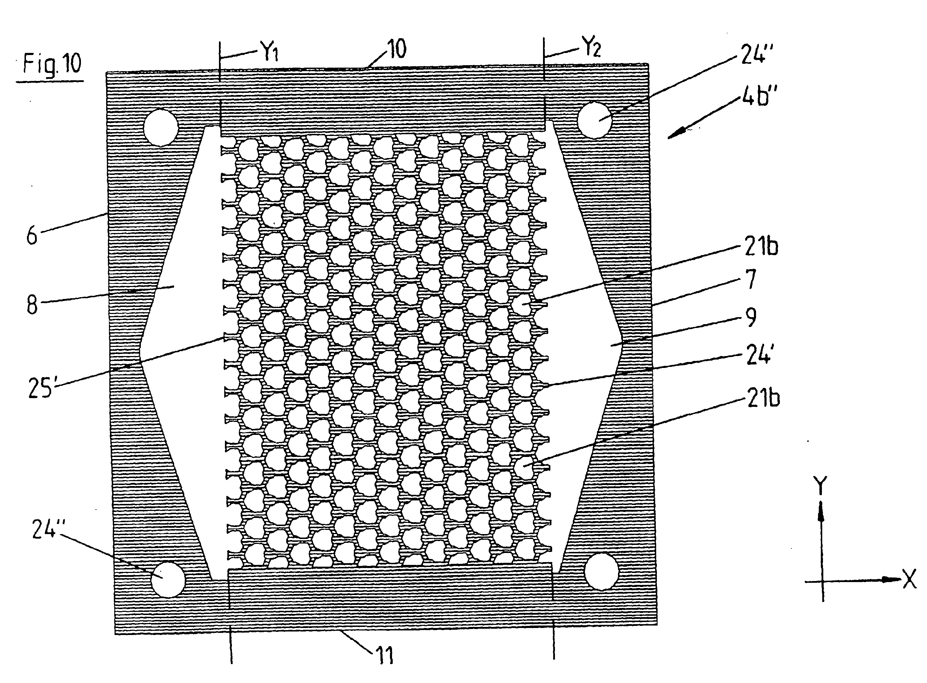

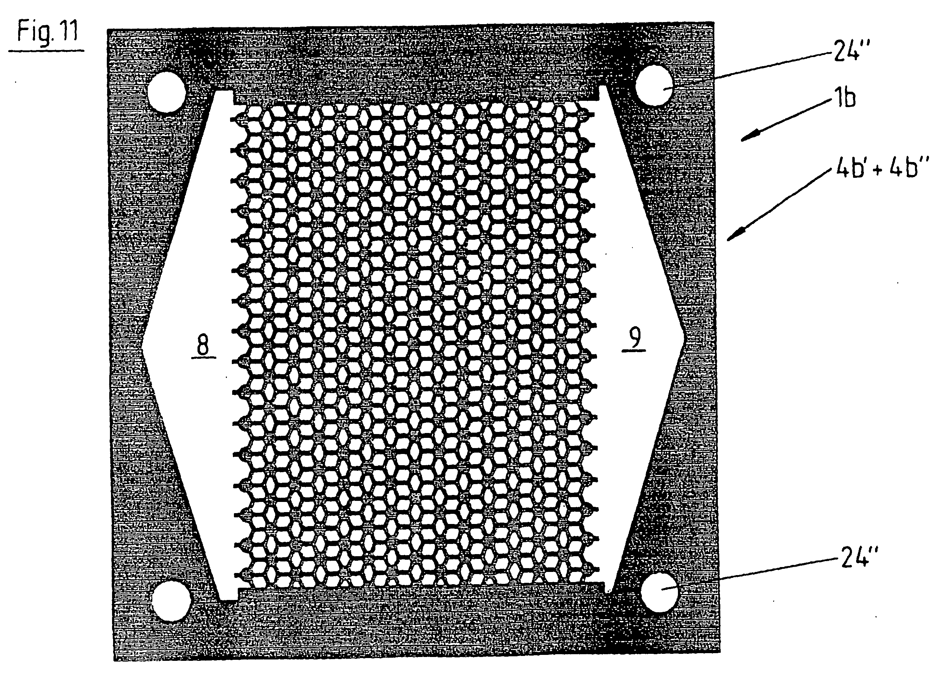

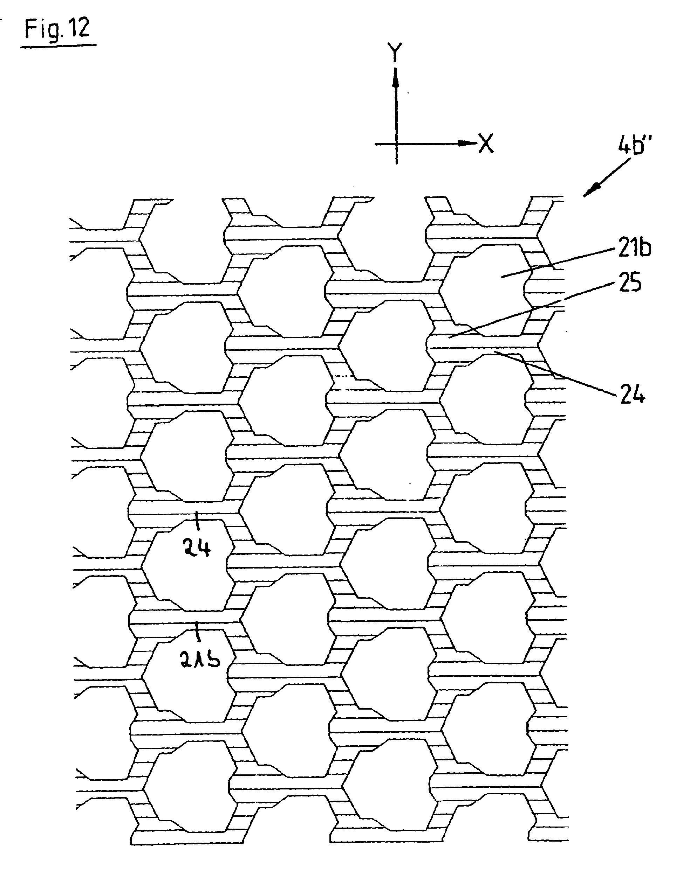

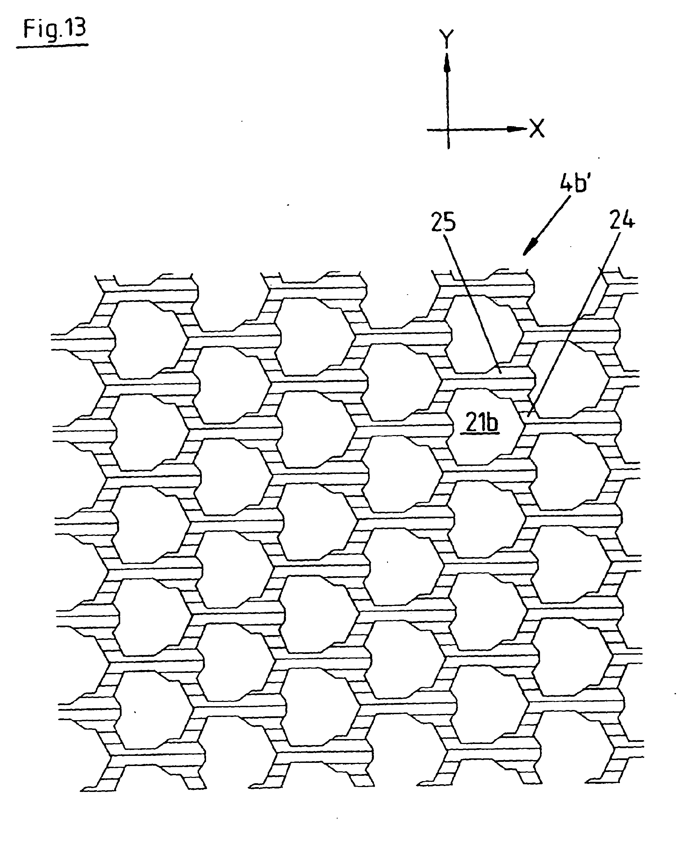

Die Figuren 9 - 13 zeigen in ähnlichen Darstellungen wie die Figuren 2 - 7 Kühlerlagen 4b' bzw. 4b" bei einem weiteren möglichen Kühler 1b der Erfindung. Diese Kühlerlagen unterscheiden sich von den Kühlerlagen 4a' bzw. 4a" lediglich dadurch, daß die Bereiche 20b' bzw. 20b" so strukturiert sind, daß die Materialstege 24 wiederum aneinander anschließende hexagonale Ringstrukturen mit Durchbrechungen 21b bilden. Allerdings ist jeweils nur an drei Eckpunkten jedes gleichseitigen Sechsecks jeder Ringstruktur eine Insel 25 vorgesehen, und zwar derart, daß die Mittelpunkte der Inseln 25 bei jeder Ringstruktur die Eckpunkte eines gleichseitigen Dreiecks bilden, wobei zwei dieser Eckpunkte auf einer gemeinsamen, sich in Richtung der Y-Achse erstreckenden Linie oder Dreieck-Seite befinden. Bei der Kühlerlage 4b' liegt bei jeder Ringstruktur diese gemeinsame, in Richtung der Y-Achse verlaufende Seite des gleichseitigen Dreiecks in einem größeren Abstand von der Umfangsseite 6 als die dieser Seite gegenüberliegende und von dem Mittelpunkt der dritten Insel 25 gebildete Dreieckspitze.

Bei der Kühlerlage 4b' befinden sich die Enden 24' wiederum im Bereich der Öffnung 8 und die Enden 25' im Bereich der Öffnung 9.

Die Kühlerlage 4b" ist so ausgebildet, daß ihre Struktur praktisch derjenigen der um die Mittelachse M um 180° gedrehten bzw. gewendeten Kühlerlage 4b' entspricht.

Durch wechselweises Aufeinanderliegen der Kühlerlagen 4b' und 4b" in dem den Kühler 1b bildenden Stapel ergeben sich wiederum durch in allen Stapeln durchgehend aneinander anschließende Insel 25 Säulen 22 und zwischen diesen Säulen Bereiche, die von dem Kühlmedium von oben nach unten oder umgekehrt durchströmt werden können und in denen sich die von den Säulen 22 wegerstreckenden Materialstege 24 mit den nicht von Inseln 25 gebildeten Verzweigungspunkten zwischen jeweils drei Materialstegen 24 befinden.

Bei den Kühlern 1a und 1b überdeckt jede Durchbrechung 21a bzw. 21b in einer Kühlerlage jeweils zwei Durchbrechungen 21a bzw. 21b in einer benachbarten Kühlerlage. Weiterhin sind die Kühlerlagen mit ihren Durchbrechungen so angeordnet, daß die Durchbrechungen jeder zweiten Kühlerlage in der Achsrichtung senkrecht zur Ebene der Kühlerlagen deckungsgleich liegen.

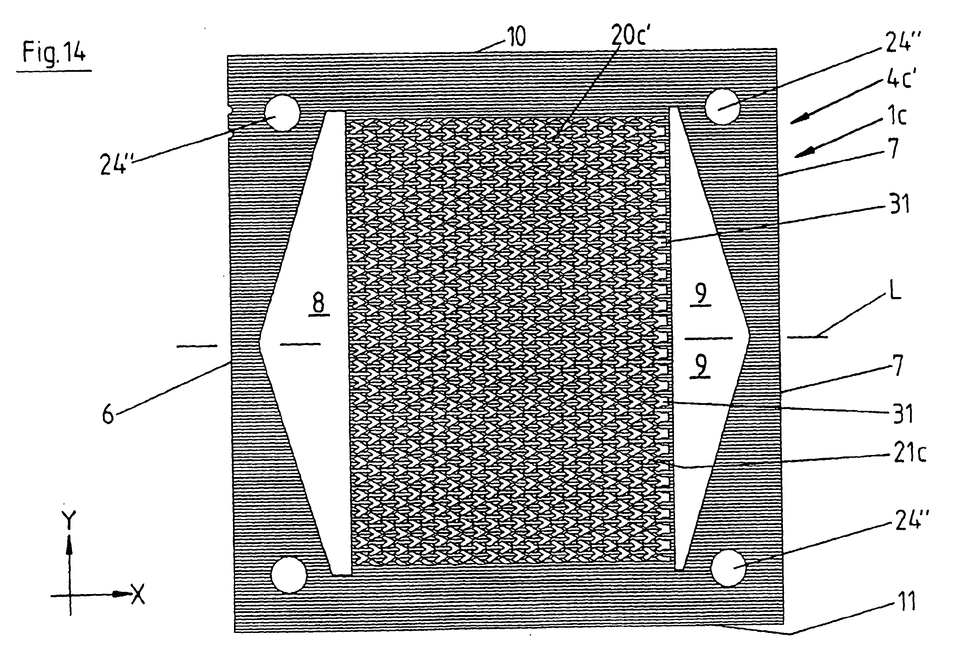

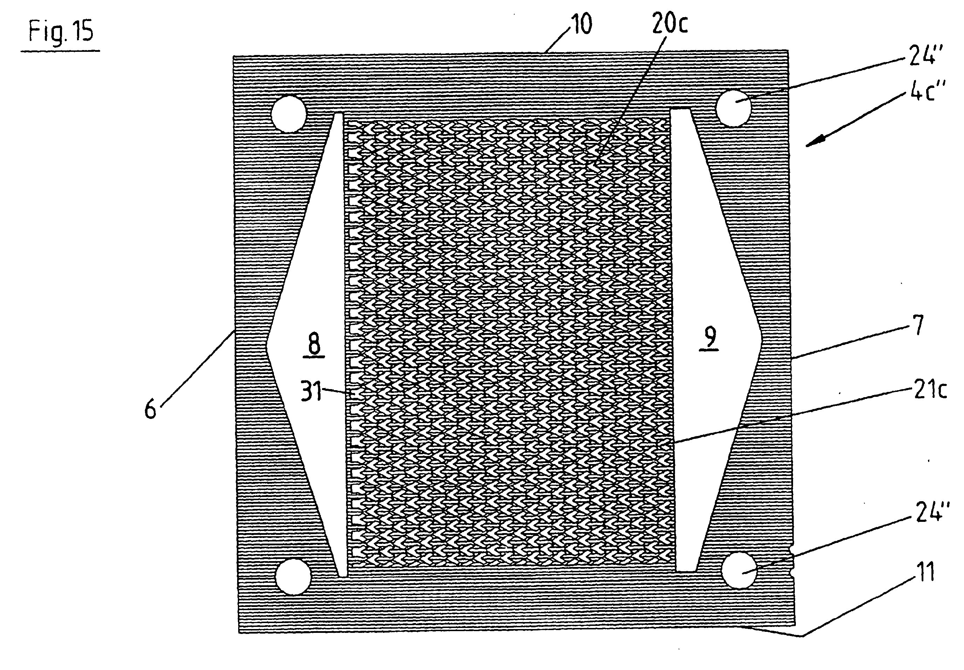

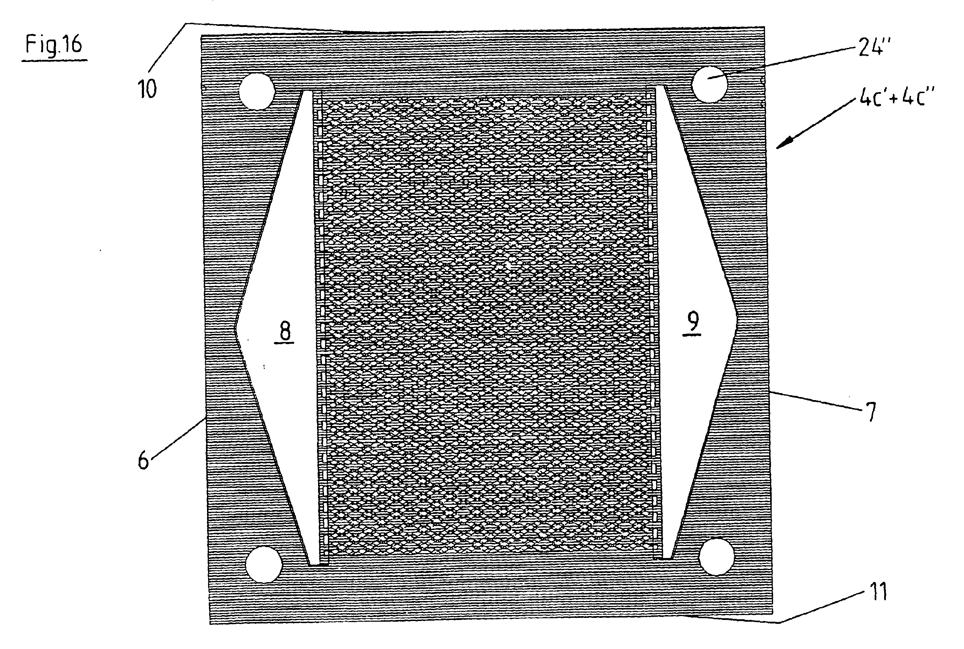

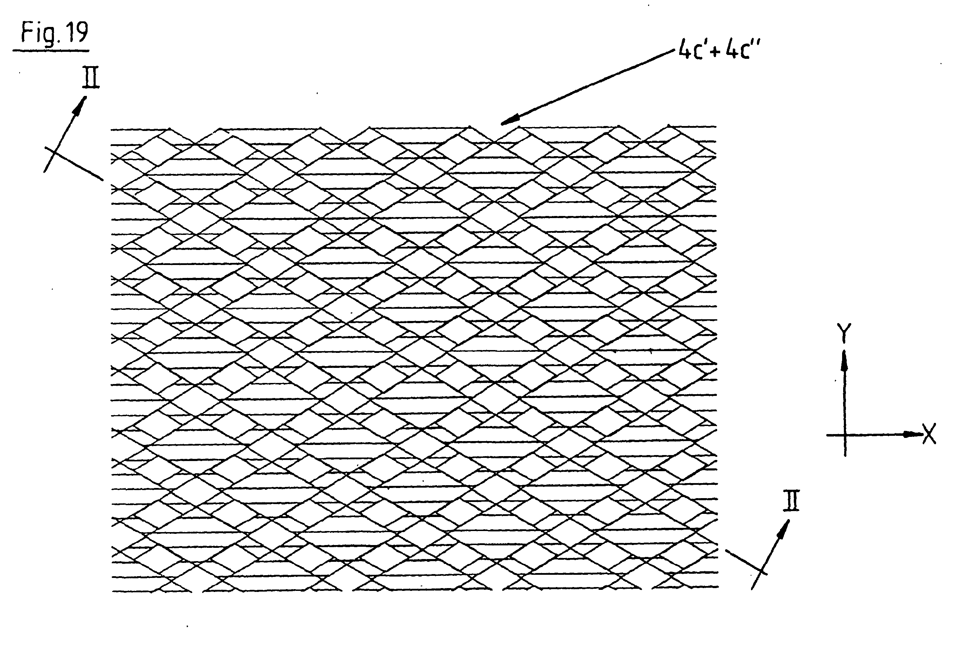

Die Figuren 14 - 20 zeigen als weitere mögliche Ausführungsform einen Kühler 1c und die diesen Kühler bildenden Kühlerlagen 4c' und 4c". Die Kühlerlagen 4c' und 4c" unterscheiden sich von den Kühlerlagen 4a' und 4a" wiederum lediglich durch die Art der Strukturierung der Bereiche 20c' und 20c", d.h. abgesehen von der nachstehend näher beschriebenen Ausgestaltung gelten auch für diese Kühlerlagen die vorstehenden Aussagen zu den Kühlerlagen 4a' und 4a".

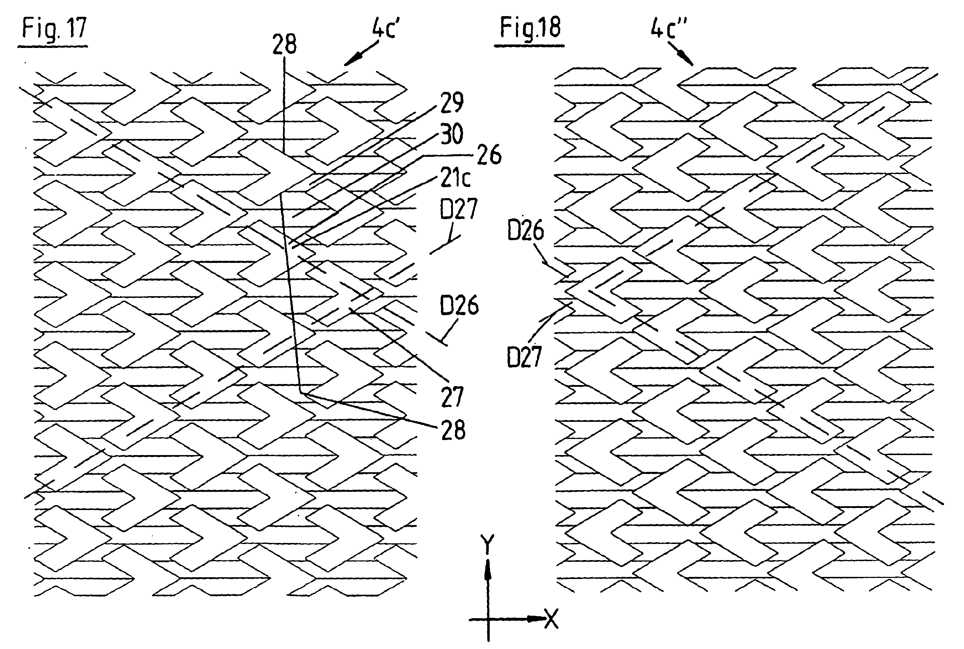

Wie insbesondere die Figuren 14 und 17 zeigen, ist der siebartig strukturierte Bereich 20c' der Kühlerlage 4c' dadurch gebildet, daß in das Material eine Vielzahl von Durchbrechungen 21c eingebracht ist, von denen jede aus zwei ineinander übergehenden Schlitzen oder Abschnitten 26 und 27 besteht, die mit ihrer Längserstreckung auf einer Diagonalen D26 (Abschnitt 26) bzw. auf einer Diagonalen D27 (Abschnitt 27) liegen, welche mit der X-Achse einen Winkel kleiner als 90° einschließen. Bei der dargestellten Ausführungsform bildet die X-Achse jeweils die Winkelhalbierende der sich schneidenden Diagonalen D26 und D27, die in ihren jeweiligen Schnittpunkt einen Winkel kleiner als 90° einschließen. Die von den Diagonalen D26 und D27 gebildeten Schnittwinkel öffnen sich jeweils zu der Umfangsseite 6 bzw. zu der Öffnung 8. Weiterhin sind bei sämtlichen Durchbrechungen 21c die außenliegenden Seitenlängen 28 der Abschnitte 26 und 27 gleich. Weiterhin liegen eine Vielzahl der Durchbrechungen 21c mit ihren Abschnitten 26 jeweils auf einer gemeinsamen Diagonale D26 und mit ihren Abschnitten 27 ebenfalls auf einer gemeinsamen Diagonale D27, wobei eine Vielzahl solcher Diagonalen D26 parallel und im Abstand voneinander sowie auch eine Vielzahl von Diagonalen 27 parallel und in Abstand voneinander derart vorgesehen sind, daß entlang jeder Diagonalen D26 jeweils eine Durchbrechung 21c bzw. deren Abschnitt 26 mit einem dazwischenliegenden Materialsteg 29 an eine Durchbrechung 21c bzw. deren Abschnitt 26 anschließt. Ebenso sind die Durchbrechungen 21c so angeordnet, daß in Richtung jeder Diagonale D27 jede Durchbrechung 21c bzw. deren Abschnitt 27 über einen Materialsteg 30 an eine weitere Durchbrechung 21c bzw, deren Abschnitt 27 anschließt usw.

An der Öffnung 8 weist der Bereich 20c' einen geschlossenen Rand auf, an den sich zur Mittelachse M hin eine erste, in Richtung der Y-Achse erstreckende Reihe einer Vielzahl von Durchbrechungen 21c anschließt.

An der Öffnung besitzt der Bereich 20c' ebenfalls einen geschlossenen Rand, an welchem sich zur Mittelachse M hin eine sich in Richtung der Y-Achse erstreckende Reihe von Durchbrechungen 31 anschließt, die bei der dargestellten Ausführungsform im wesentlichen quadratisch ausgeführt sind und in die jeweils eine Durchbrechung 21c mit ihren von der Überlappung der Abschnitten 26 und 27 gebildeten Winkelbereich übergeht. Die Anordnung der Durchbrechungen 21c' ist weiterhin so getroffen, daß sich jede Diagonale 26 mit einer Diagonale D27 auf der Längsachse L schneidet.

Die Kühlerlage 4c" ist hinsichtlich der Strukturierung des Bereiches 20c" wiederum identisch mit der um die Mittelachse M um 180° gedrehten bzw. gewendeten Kühlerlage 4c'.

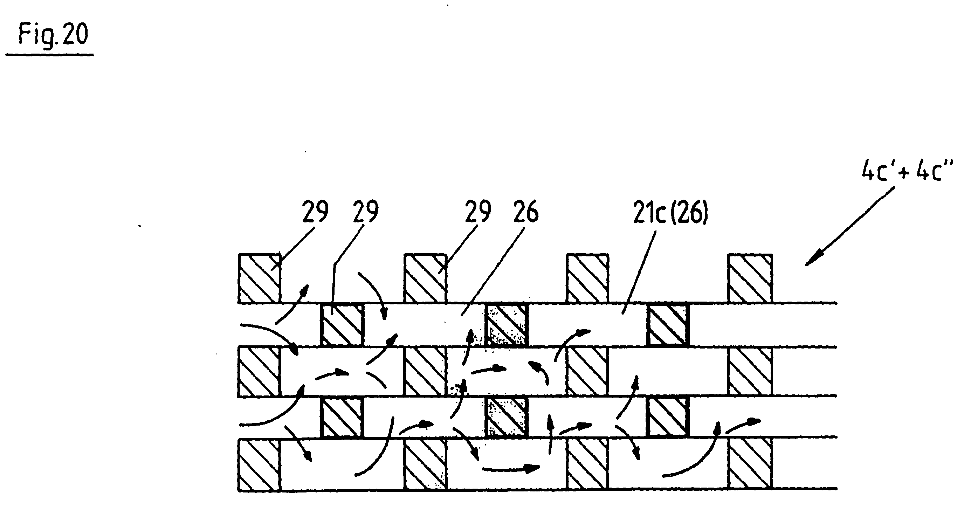

Durch die vorstehend beschriebene Ausbildung der beiden Kühlerlagen 4c' und 4c" ist erreicht, daß bei in dem Stapel abwechselnd übereinander angeordneten und mit ihren Bohrungen 24 deckungsgleichen Kühlerlagen 4c' und 4c" jede Diagonale D26 einer Kühlerlage 4c deckungsgleich mit einer Diagonale D26 der benachbarten Kühlerlage liegt und gleiches auch für die Diagonale D27 gilt, wobei sich die Durchbrechungen 21c benachbarter Kühlerlagen jeweils an den Enden der Abschnitte 26 und 27 überlappen, und zwar in einem Bereich, der kleiner ist als die Seitenlänge 28, und wobei die Kühlerlagen 4c' und 4c" mit den Materialbereichen 32, die jeweils zwischen benachbarten Durchbrechungen 21c außerhalb der Materialstege 29 und 30 gebildet sind; sich durchgehend überlappen und dadurch Säulen 22 gebildet sind. Außerhalb dieser durchgehenden Säulen weist der Kühler 1c eine innere Struktur auf, die ein Durchströmen des Kühlers mit dem Kühlmedium ermöglicht, und zwar unter ständigem Wechsel der Ebenen und unter intensiven Durchströmen der außerhalb der Pfosten 21 befindlichen Materialabschnitte, insbesondere auch der Materialstege 29 und 30, wie dies in der Figur 20 mit den dortigen Pfeilen angedeutet ist, die einen Schnitt entsprechend der Schnittlinie II - II, d.h. entlang einer Diagonalen D26 wiedergibt. Wie die Figur 20 auch zeigt, liegt hier jeder Durchbrechung 21c bzw. dem Abschnitt 26 dieses Durchbrechung ein Materialsteg 29 einer benachbarten Kühlerlage gegenüber, wobei sich der Materialsteg 29 jeweils in der Mitte eines gegenüberliegenden Abschnittes 26 befindet. Ein gleiches Bild ergibt sich bei einem Schnitt entlang der Diagonalen D27.

Bei dem Kühler 1c überdeckt somit ebenfalls jede Durchbrechung 21c in einer Kühlerlage jeweils zwei Durchbrechungen 21c in einer benachbarten Kühlerlage. Weiterhin sind die Kühlerlagen mit ihren Durchbrechungen 21c so angeordnet, daß die Durchbrechungen jeder zweiten Kühlerlage gleichsinnig orientiert sind und in der Achsrichtung senkrecht zur Ebene der Kühlerlagen deckungsgleich liegen.

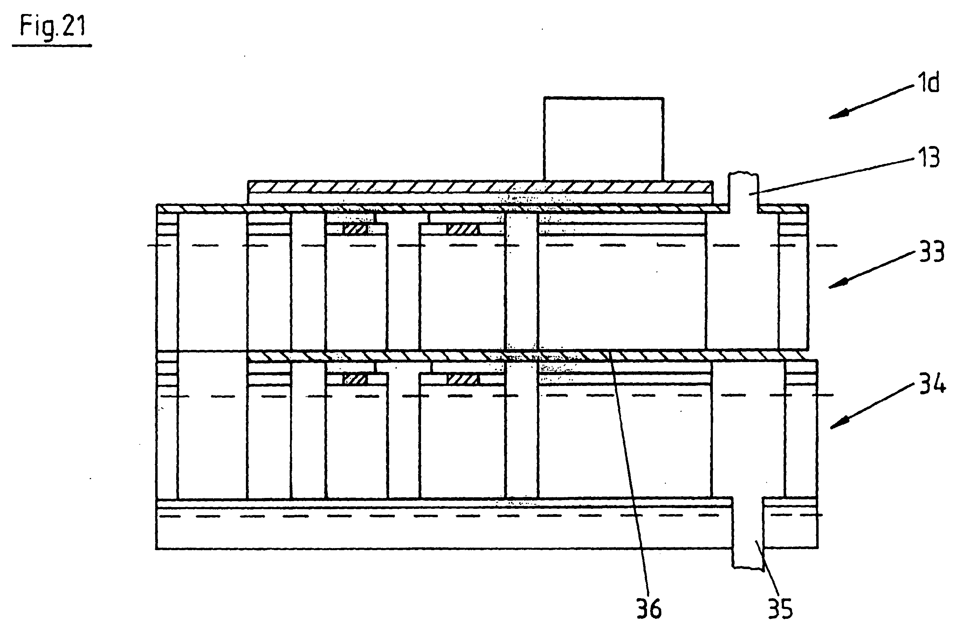

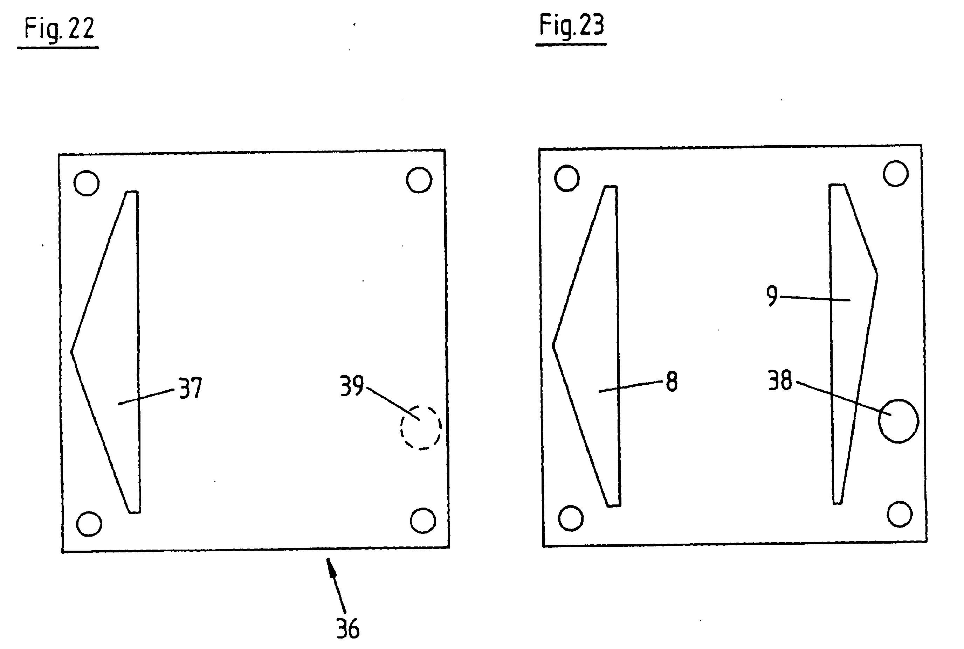

Die Figur 21 zeigt als weitere mögliche Ausführungsform einen Kühler 1d, der sich von dem Kühler 1 im wesentlichen nur dadurch unterscheidet, daß zwei Einzelkühler 33 und 34, die beispielsweise jeweils entsprechend dem Kühler 1a, 1b oder 1c ausgebildet sind, übereinander vorgesehen sind. Die beiden Einzelkühler 33 und 34 sind von dem Kühlmedium im Gegenstrom durchströmt, und zwar derart, daß das Kühlmedium an einem Einlaß 35 des unteren Kühlers 34 zugeführt wird und den oberen Kühler 33 an dem dortigen Anschluß 13 verläßt. Um das gewünschte Durchströmen der beiden Kühler 33 und 34 zu erreichen, ist eine Zwischen- oder Trennlage 36 zwischen diesen beiden Kühlern vorgesehen. Die in der Figur 22 wiedergegebene Trennlage 36 besteht im wesentlichen aus einem Metallblech oder einer Metallfolie, die ein Fenster 37 aufweisen, welches eine Verbindung zwischen den beiden Sammelräumen 8' des unteren und oberen Einzelkühlers 33 bzw. 34 herstellt, die Sammelräume 9' dieser Kühler aber trennt.

Grundsätzlich besteht beim Kühler 1d auch die Möglichkeit, die Anschlüsse 13 und 35 an einer gemeinsamen Seite, nämlich beispielsweise an der Oberseite des Kühlers 1d vorzusehen. In diesem Fall sind die Öffnungen 9 der den oberen Kühler 33 bildenden Kühlerlagen 4 in der in der Figur 23 wiedergegebenen Weise ausgeführt, und zwar derart, daß zusätzlich zu der Öffnung 9 jeder Kühlerlage eine getrennte Bohrung 38 vorgesehen ist. Bei montiertem Kühler 1d liegen diese Bohrungen 38 sämtlicher Kühlerlagen 4 deckungsgleich miteinander und deckungsgleich mit einer Bohrung 39, die in der Trennlage 36 vorgesehen ist und in den Sammelraum 9 des unteren Kühlers 34 mündet. Die Bohrungen 38 und 39 bilden dann einen Kanal, über den das Kühlmedium an der Oberseite des Kühlers 1d zugeführt werden kann.

In analoger Weise ist es dann auch möglich, daß Kühlmedium beim Kühler 1d lediglich an der Unterseite zuzuführen. In diesem Fall sind die Kühlerlagen des unteren Einzelkühlers 34 entsprechend der Figur 23 ausgebildet, wobei die Trennlage 36 wiederum die in der Figur 22 dargestellte Ausführung aufweist.

Als Kühlmedium eignet sich bei dem erfindungsgemäßen Kühler bevorzugt ein flüssiges Medium, beispielsweise Wasser, Öl usw.

Grundsätzlich kann der erfindungsgemäße Kühler auch als Verdampfungskühler ausgebildet sein, und zwar beispielsweise als "Heat-Pipe" oder Verdampfungs-Kühler jeweils unter Verwendung eines Kühlmediums, welches dem Kühler zunächst flüssig zugeführt wird und dann im Kühler bzw. in dem dort gebildeten Strömungslabyrinth verdampft und als Dampf am Kühlmediumrücklauf abgeführt und außerhalb des Kühlers durch Abgabe von Wärme wieder verflüssigt.

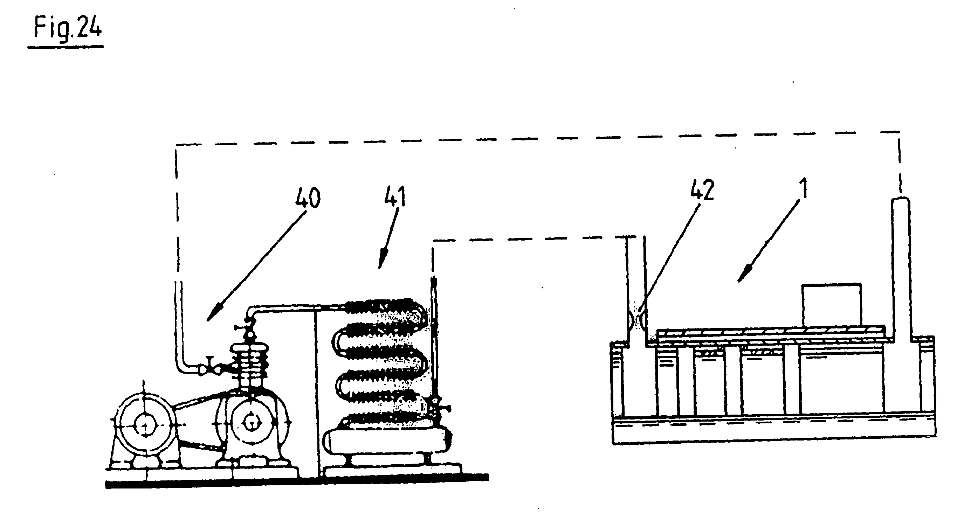

In der Figur 24 ist sehr schematisch ein solcher Verdampfungs-Kühlkreis wiedergegeben, der u.a. einen Kompressor 40, einen externen Wärmetauscher bzw. Kühler 41 und eine am Kühler 1, beispielsweise am Einlaß zu dem Sammelkanal 8' vorgesehene Expansionsdüse 42 aufweist. Das mit dem Kompressor 14 verflüssigte und im externen Kühler 41 abgekühlte flüssige Kühlmedium wird im Kühler 1 expandiert und nach dem Durchströmen des Kühlers 1 am Sammelraum 9' in gasförmiger Form gesammelt und an den Kompressor 40 zurückgeführt.

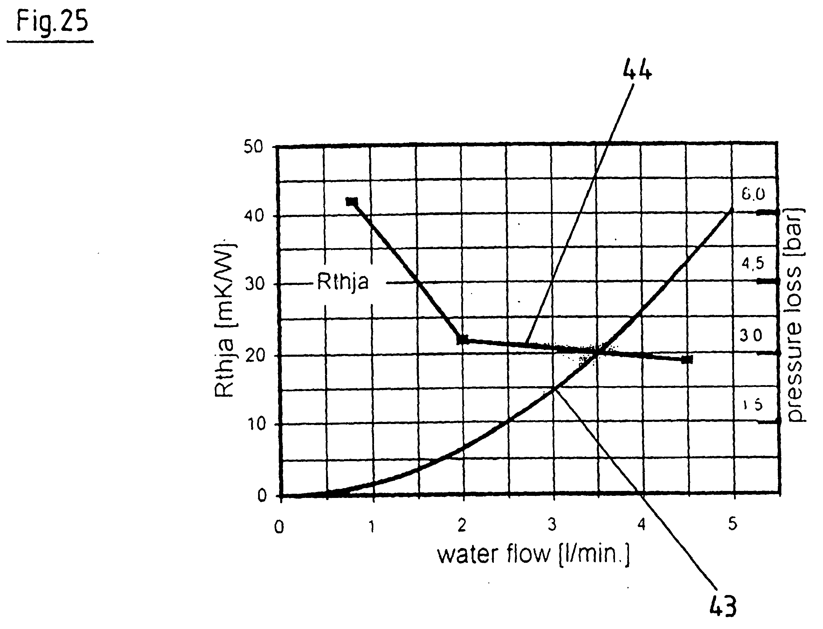

Das Diagramm der Fig. 25 zeigt in der Kurve 43 den Druckverlust innerhalb des Kühlers 1 und in der Kuve 44 die Kühlwirkung, jeweils in Abhängigkeit vom der Durchflußmenge des Kühlmedium.

### Bezugszeichenliste

- 1, 1a, 1b: Kühler
- 1c, 1d: Kühler
- 2, 3: Abschlußlage
- 4, 4d: Kühlerlage
- 4a', 4a": Kühlerlage
- 4b', 4b": Kühlerlage
- 4c', 4c": Kühlerlage
- 6, 7: Umfangsseite
- 8, 9: Öffnung
- 8', 9': Sammelraum
- 10, 11: Umfangsseite
- 12, 13: Anschluß
- 14: Keramikschicht
- 15: Metallisierung
- 16: Bauelement
- 17: Trägerelement
- 18: Kanal
- 19: Keramikschicht
- 20: Bereich
- 20a', 20a": Bereich
- 20b', 20b": Bereich
- 20c', 20c": Bereich
- 21, 21a: Durchbrechung
- 21b, 21c: Durchbrechung
- 22: Säule
- 23: Zuschnitt
- 24: Materialsteg
- 24': Ende
- 25: Insel
- 25': Ende
- 26, 27: Abschnitt
- 28: Seitenkante
- 29, 30: Materialsteg
- 31: Durchbrechung
- 32: Materialbereich
- 33, 34: Einzelkühler
- 35: Anschluß
- 36: Trennlage
- 37: Fenster
- 38, 39: Bohrung
- 40: Kompressor
- 41: externer Kühler
- 42: Düse

## Patentansprüche

1. Kühler zur Verwendung als Wärmesenke für elektrische Bauelemente oder Schaltkreise, bestehend aus aus einer Vielzahl von stapelartig übereinander angeordneten und flächig mit einander verbundenen Kühlerlagen (4), die zwischen sich von einem Kühlmedium durchströmbare Kanäle bilden, welche jeweils in wenigstens einen ersten Sammelraum (8') mit einem äußeren Anschluß (12) zum Zuführen des Kühlmediums und in einen zweiten Sammelraum (9') mit äußerem Anschluß (13) zum Abführen des Kühlmediums münden, wobei die Sammelräume (8', 9') durch Öffnungen (8, 9) in den Kühlerlagen (4) und die Kühlkanäle durch Strukturierung wenigstens eines zwischen den Öffnungen (8, 9) liegenden Bereichs (20) der Kühlerlagen mit Durchbrüchen (21) gebildet sind, der wenigstens eine zwischen den Öffnungen (8, 9) liegende Bereich (20) in den Kühlerlagen (4) siebartig mit einer Vielzahl von jeweils an ihrem Umfang geschlossenen Durchbrechungen (21, 21a, 21b, 21c) derart strukturiert ist, daß bei im Kühler stapelartig übereinander angeordneten Kühlerlagen (4) sich erste Materialabschnitte (25, 32) des um die Durchbrechungen (21, 21a, 21b, 21c) verbliebenen Materials der siebartig strukturierten Bereiche durchgehend von Kühlerlage zu Kühlerlage überlappen, wobei durch die durchgehenden Überlappungen eine Vielzahl von durchgehenden und vom Kühlmedium umströmbaren Säulen (22) gebildet sind, und wobei jeder Durchbrechung (21, 21a, 21b, 21c) einer Kühlerlage ein sich von der Säule wegerstreckender weiterer Materialabschnitt (24, 29, 30) einer benachbarten Kühlerlage derart gegenüberliegt, daß an diesem Materialabschnitt vorbei ein Durchtritt des Kühlmediums durch die betreffende Durchbrechung (21, 21a, 21b, 21c) möglich ist,
**dadurch gekennzeichnet,**
**daß** die Säulen (22) von dem Kühlmedium nach dem Durchtritt durch eine Durchbrechung (21, 21a, 21b, 21c) allseitig, d.h. jeweils links und echts umströmbar sind.

2. Kühler nach Anspruch 1, **dadurch gekennzeichnet, daß** die Durchbrechungen (21, 21a, 21b, 21c) und die den Durchbrechungen benachbarten Materialabschnitte (24, 29, 30) in den Ebenen ständig wechselnde Strömungswege für das Kühlmedium zwischen den wenigstens zwei Sammelräumen (8', 9') bilden.

3. Kühler nach Anspruch 1 oder 2, **dadurch gekennzeichnet, daß** die Durchbrechungen (21, 21a, 21b) Querschnittsabmessungen aufweisen, die größer sind als die Abmessungen oder die Breite des jeweiligen einer Durchbrechung gegenüber liegenden Materialabschnitts.

4. Kühler nach einem der vorhergehenden Ansprüche, **dadurch gekennzeichnet, daß** die Durchbrechungen (21, 21a, 21b) Abmessungen aufweisen, die größer sind als die Abmessungen oder Breite der diese Durchbrechungen umgebenden Materialabschnitte oder -stege.

5. Kühler nach einem der vorhergehenden Ansprüche, **dadurch gekennzeichnet, daß** die Durchbrechungen (27a, 27b) jeweils von netzartig sich verzweigenden oder ineinander übergehenden Materialstegen (24) umschlossen sind, die um jede Durchbrechung (21, 21a, 21b) eine Polygon- oder Ringstruktur bilden.

6. Kühler nach einem der vorhergehenden Ansprüche, **dadurch gekennzeichnet, daß** die Materialstege (24) um jede Durchbrechung (21a, 21b) eine sechseckförmige Ringstruktur bilden, wobei vorzugsweise wenigstens drei, ein Dreieck, vorzugsweise ein gleichseitiges Dreieck, bildende Eckpunkte der Ringstruktur flächenmäßig vergrößert bzw. als Inseln (25) ausgebildet sind, wobei vorzugsweise sämtliche Eckpunkte der Polygon- oder Ringstruktur flächenmäßig vergrößert bzw. als Inseln (25) ausgebildet sind.

7. Kühler nach einem der Ansprüche 6 - 8, **dadurch gekennzeichnet, daß** die durchgehenden Säulen (22) von Eckpunkten der Ringstruktur gebildet sind.

8. Kühler nach einem der Ansprüche 6 - 9, **dadurch gekennzeichnet, daß** bei sechseckförmigen Ringstrukturen zwei einander gegenüberliegende und parallel zueinander angeordnete Polygon-Seiten jeder Ringstruktur in einer ersten Achsrichtung (X-Achse) orientiert sind, und daß bei gleicher oder im wesentlichen gleicher Stnrkturierung des siebartigen Bereiches (20a', 20a"; 20b - 20b") der im Kühler einander benachbarten Kühlerlagen (4a', 4a"; 4b - 4b") die strukturierten Bereiche jeweils um die Länge einer Sechseck-Seite in der ersten Achsrichtung (X-Achse) versetzt vorgesehen sind.

9. Kühler nach einem der vorhergehenden Ansprüche, **dadurch gekennzeichnet, daß** die Kühlerlagen identisch ausgebildet sind und im Kühler jede Kühlerlage einer weiteren, gewendeten oder umgedrehten Kühlerlage benachbart liegt.

10. Kühler nach einem der vorhergehenden Ansprüche, **dadurch gekennzeichnet, daß** der strukturierte Bereich (20c', 20c") jeder Kühlerläge (4c', 4c") eine Vielzahl von beispielsweise winkelförmig ausgebildeten Durchbrechungen (21c) aufweist, die jeweils von zwei sich kreuzenden oder schneidenden Öffnungsabschnitten (26, 27) gebildet sind, und daß benachbarte Kühlerlagen (4c', 4c") derart aneinander anschließen, daß sich die Durchbrechungen (21c) benachbarter Kühlerlagen jeweils nur in einem Teilbereich überlappen, zwischen benachbarten Durchbrechungen (21c) einer Kühlerlage gebildete Materialabschnitte oder-stege (29, 30) einer Durchbrechung der benachbarten Kühlerlage gegenüberliegen und zwischen den Durchbrechungen (21c) verbliebene Materialabschnitte (32) die durchgehenden Säulen (22) bilden,
wobei vorzugsweise jede Durchbrechung (21) einen ersten Öffnungsabschnitt (26) und einen diesen schneidenden oder in diesen übergehenden zweiten Öffnungsabschnitt (27) aufweist und die ersten Öffnungsabschnitte (26) einer Vielzahl von Durchbrechungen (21c) jeweils auf einer gemeinsamen ersten Achslinie bzw. Diagonalen (D26) aufeinander folgend und durch Materialstege (29) voneinander getrennt vorgesehen sind und die zweiten Öffnungsabschnitte (27) einer Vielzahl von Durchbrechungen (21c) jeweils auf einer zweiten Achslinie bzw. Diagonalen (D27) aufeinander folgend und durch Materialstege (30) voneinander getrennt vorgesehen sind.

11. Kühler nach Anspruch 10, **dadurch gekennzeichnet,**
**daß** sich die Diagonalen (D26, D27) unter einem Winkel, vorzugsweise unter einem Winkel gleich oder kleiner 90° schneiden, und/oder
**daß** die Durchbrechungen (21c) bzw. deren Diagonale (D26, D27) einen Winkel einschließen, der sich bei einander benachbarten Kühlerlagen (4c - 4c") zu entgegengesetzten Seiten hin öffnet.

12. Kühler nach einem der vorhergehenden Ansprüche, **dadurch gekennzeichnet, daß** sich die Durchbrechungen benachbarter Kühlerlagen jeweils an Endbereichen der Öffnungsabschnitte (26, 27) überlappen, die von demjenigen Bereich entfernt liegen, an dem die Abschnitte ineinander übergehen bzw. einander schneiden.

13. Kühler nach einem der vorhergehenden Ansprüche, **dadurch gekennzeichnet,**
**daß** zumindest ein Teil der Kühlerlagen aus Metall oder einer Metallfolie, beispielsweise aus Kupfer besteht, und/oder
**daß** die Kühlerlagen (4) unter Verwendung der DCB-Technik oder durch Diffusions-Bonden miteinander verbunden sind.

14. Kühler nach einem der vorhergehenden Ansprüche, **dadurch gekennzeichnet, daß** er an seiner Oberseite und/oder an seiner Unterseite mit wenigstens einer Schicht (14, 19) aus Keramik versehen ist

15. Kühler nach einem der vorhergehenden Ansprüche, **dadurch gekennzeichnet, daß** an wenigstens einer Seite des Kühlers elektrische Bauelemente (16) vorgesehen sind.

16. Kühler nach einem der vorhergehenden Ansprüche, **dadurch gekennzeichnet, daß** die Keramikschicht mit einer Metallisierung (15), vorzugsweise mit einer Leiterbahnen, Kontaktflächen, Befestigungsflächen usw. bildenden Metallisierung (15) versehen ist.

17. Kühler nach einem der vorhergehenden Ansprüche, **dadurch gekennzeichnet, daß** wenigstens zwei Einzelkühler (33, 34) kaskardenartig zu einem Gesamtkühler (1d) verbunden sind, wobei vorzugsweise zwischen den Kühlern eine Trennlage (36) vorgesehen ist.

18. Kühler nach einem der vorhergehenden Ansprüche, **dadurch gekennzeichnet, daß** als Kühlmedium ein flüssiges Medium, beispielsweise Wasser, Öl verwendet ist.

19. Kühler nach einem der vorhergehenden Ansprüche, **gekennzeichnet durch** seine Ausbildung als Verdampfungskühler.

20. Kühler nach einem der vorhergehenden Ansprüche, **dadurch gekennzeichnet,**
**daß** jede Durchbrechung (21, 21a, 21b, 21c) in einer Kühlerlage (4, 4a', 4a"; 4b, 4b"; 4c', 4c") wenigstens zwei Durchbrechungen (21, 21a, 21b, 21c) in einer benachbarten Kühllage zumindest teilweise überlappt, und/oder
**daß** die Durchbrechungen (21, 21a, 21b, 21c) jeder zweiten Kühlerlage (4, 4a', 4a"; 4b, 4b"; 4c', 4c") deckungsgleich miteinander angeordnet sind.

21. Elektrischer Schaltkreis mit wenigstens einem elektrischen oder elektronischen Bauelement (16) und mit einem Kühler als Wärmesenke für das Bauelement (16), **gekennzeichnet durch** die Ausbildung des Kühlers nach einem der Ansprüche 1-20.

## Claims

1. Cooler for use as a heat sink for electrical modular elements or circuits, consisting of a number of cooler layers (4) which are mounted stacked one above the other and are connected to one another over a flat surface area and which form between them ducts through which flows a cooling medium whereby each duct opens into at least a first collecting chamber (8') with external connection (12) for supplying the cooling medium and into a second collecting chamber (9') with external connection (13) for discharging the cooling medium, wherein the collecting chambers (8',9') are formed through openings (8,9) in the cooler layers (4) and the cooling ducts are formed by structuring in at least one area (20) of the cooler layers (4) which lies between the openings (8,9) and has apertures (21), the at least one area (20) lying between the openings (8,9) in the cooler layers (4) has a screen-like structure with several apertures (21, 2a, 21b, 21c) each closed around the periphery so that when the coolers (4) are arranged stacked one above the other in the cooler first material sections (25, 32) of the material of the screen-type structured areas remaining around the apertures (21, 21a, 21b, 21c) continuously overlap from cooler layer to cooler layer whereby the continuous overlaps form a number of continuous columns (22) through which the cooling medium flows, and wherein opposite each aperture (21, 21a, 21b, 21c) of a cooler layer is a further material section (24, 29, 30) of an adjacent cooler layer extending away from the column so that a passage of the cooling medium through the relevant aperture (21, 21a, 21b, 21c) is possible past this material section ,
**characterised in that** the cooling medium flows round the columns (22) on all sides, i.e. left and right, after passing through an aperture (21, 21a, 21b, 21c)..

2. Cooler according to claim 1 **characterised in that** the apertures (21, 21a, 21b, 21c) and the material sections (24, 29, 30) adjoining the apertures form constantly changing flow paths in the planes for the cooling medium between the at least two collecting chambers (8',9').

3. Cooler according to claim 1 or 2 **characterised in that** the apertures (21, 21a, 21b) have cross-sectional dimensions which are greater than the dimensions or the width of each material section opposite the relevant aperture.

4. Cooler according to one of the preceding claims **characterised in that** the apertures (21, 21a, 21b) have dimensions which are greater than the dimensions or width of the material sections or webs surrounding these apertures.

5. Cooler according to one of the preceding claims **characterised in that** the apertures (21a, 21b) are each surrounded by material webs (24) which branch out like a mesh or run into each other to form a polygon or ring structure around each aperture (21, 21a, 21b).

6. Cooler according to one of the preceding claims **characterised in that** the material webs (24) form around each aperture (21a, 21b) a hexagonal shaped ring structure wherein preferably at least three corner points of the ring structure forming a triangle, preferably an equilateral triangle, are enlarged flat or designed as islands (25) wherein preferably all the corner points of the polygon or ring structure are enlarged flat or formed as islands (25).

7. Cooler according to one of claims 6 to 8 **characterised in that** the continuous columns (22) are formed by corner points of the ring structure.

8. Cooler according to one of claims 6 to 9 **characterised in that** in the case of hexagonal ring structures two opposing polygon sides arranged parallel to one another of each ring structure are aligned in a first axial direction (X-axis) and that with the same or substantially the same structuring of the screen-type area (20a', 20a"; 20b-20b") of the cooler layers (4a',4a"; 4b,-4b") which are adjacent one another in the cooler the structured areas are each off-set in the first axial direction (X-axis) by the length of one hexagon side.

9. Cooler according to one of the preceding claims **characterised in that** the cooler layers are formed identical and in the cooler each cooler layer lies adjacent a further turned or rotated cooler layer.

10. Cooler according to one of the preceding claims **characterised in that** the structured area (20c', 20c") of each cooler layer (4c', 4c") has a number of for example angular shaped apertures (21c) which are each formed by two criss-crossing or intersecting opening sections (26, 27) and that adjacent cooler layers (4c',4c") adjoin one another so that the apertures (21c) of adjacent cooler layers each only overlap in one partial area, material sections or webs (29,30) formed between adjacent apertures (21c) of a cooler layer lie opposite an aperture of the adjacent cooler layer and material sections (32) remaining between the apertures (21c) form the continuous columns (22)
whereby preferably each aperture (21) has a first opening section (26) and a second opening section (27) which intersects same or changes into same, and the first opening sections (26) of a number of apertures (21c) are provided each following one another on a common first axial line or diagonal (D26) and are separated from each other through material webs (29), and the second opening sections (27) of a number of apertures (21c) are provided each following one another on a second axial line or diagonal (D27) and are separated from each other by material webs (30).

11. Cooler according to claim 10 **characterised in that** the diagonals (D26, D27) intersect at an angle, preferably at an angle equal to or least than 90°, and/or that the apertures (21c) or their diagonals (D26, D27) include an angle which in the case of adjacent cooler layers (4c-4c") opens towards opposite sides.

12. Cooler according to one of the preceding claims **characterised in that**
the apertures of adjacent cooler layers each overlap at the end areas of the opening sections (26, 27) which are remote from that area where the sections merge into each other or intersect one another.

13. Cooler according to one of the preceding claims **characterised in that**
at least a part of the cooler layers is made from metal or a metal foil, for example copper, and/or the cooler layers (4) are connected to one another using the DCB technique or through diffusion bonding.

14. Cooler according to one of the preceding claims **characterised in that**
it is provided on its upper side and/or on its underneath side with at least one layer (14, 19) of ceramic.

15. Cooler according to one of the preceding claims **characterised in that**
electrical modular elements (16) are provided on at least one side of the cooler.

16. Cooler according to one of the preceding claims **characterised in that** the ceramic layer is provided with metallization (15), preferably with metallization (15) forming conductor paths, contact faces, fixing faces etc.

17. Cooler according to one of the preceding claims **characterised in that** at least two individual coolers (33, 34) are connected in cascade manner to make up one overall cooler (1d) whereby a separating layer (36) is preferably provided between the coolers.

18. Cooler according to one of the preceding claims **characterised in that** a fluid medium by way of example water, oil, is used as the cooling medium.

19. Cooler according to one of the preceding claims **characterised by** its design as an evaporation cooler.

20. Cooler according to one of the preceding claims **characterised in that** each aperture (21, 21a, 21b, 21c) in one cooler layer (4, 4a', 4a", 4b, 4b", 4c', 4c") overlaps at least partially at least two apertures (21, 21a, 21b, 21c) in one adjacent cooler layer , and/or that the apertures (21, 21a, 21b, 21c) of each second cooler layer (4, 4a', 4a", 4b, 4b", 4c, 4c") are arranged to match one another.

21. Electric circuit having at least one electrical or electronic modular element (16) and a cooler as heat sink for the element (16) **characterised by** the configuration of the cooler according to one of claims 1 to 20.

## Revendications

1. Refroidisseur à utiliser comme dissipateur de chaleur pour composants ou circuits électriques, constitué d'une pluralité de couches de refroidisseur (4) disposées en pile les unes au-dessus des autres et reliées à plat les unes aux autres qui forment entre elles des canaux où peut circuler un agent réfrigérant, canaux qui débouchent respectivement dans au moins une première zone de collecte (8') avec un raccord extérieur (12) pour amener l'agent réfrigérant et dans une deuxième zone de collecte (9') avec un raccord extérieur (13) pour évacuer l'agent réfrigérant, dans lequel les zones de collecte (8', 9') sont formées par des ouvertures (8, 9) dans les couches de refroidisseur (4) et les canaux de refroidissement sont formés par structuration d'au moins une région des couches de refroidisseur située entre les ouvertures (8, 9) avec des brèches (21), ladite au moins une région (20) se trouvant entre les ouvertures (8, 9) dans les couches de refroidisseur (4) est structurée comme un crible avec une pluralité de brèches (21, 21a, 21b, 21c) respectivement fermées sur leur périmètre de telle manière que, dans les couchés de refroidisseur (4) disposées en pile les unes au-dessus des autres dans le refroidisseur, des premières sections de matière (25, 32) de la matière restant autour des brèches (21, 21a, 21b, 21c) des régions structurées comme un crible se recouvrent continuellement de couche de refroidisseur en couche de refroidisseur, une pluralité de colonnes (22) autour desquelles peut circuler l'agent réfrigérant étant formées par les recouvrements continus et une autre section de matière (24, 29, 30) d'une couche de refroidisseur voisine qui s'étend en s'écartant de la colonne étant opposée à chaque brèche (21, 21a, 21b, 21c) d'une couche de refroidisseur de telle manière qu'au niveau de cette section de matière, un passage de l'agent réfrigérant par la brèche concernée (21, 21a, 21b, 21c) soit possible,
**caractérisé en ce que** l'agent réfrigérant après le passage par une brèche (21, 21a, 21b, 21c) peut circuler autour des colonnes (22) de tous les côtés, c'est-à-dire respectivement à gauche et à droite.

2. Refroidisseur selon la revendication 1, **caractérisé en ce que** les brèches 21 (21, 21a, 21b, 21c) et les sections de matière (24, 29, 30) voisines des brèches forment entre lesdites au moins deux zones de collecte (8', 9') des voies d'écoulement alternant en permanence pour l'agent réfrigérant dans les plans.

3. Refroidisseur selon la revendication 1 ou 2, **caractérisé en ce que** les brèches (21, 21a, 21b) présentent des dimensions de section qui sont plus grandes que les dimensions ou la largeur de la section de matière concernée se trouvant à l'opposé d'une brèche.

4. Refroidisseur selon une des revendications précédentes, **caractérisé en ce que** les brèches (21, 21a, 21b) présentent des dimensions qui sont plus grandes que les dimensions ou la largeur des sections ou des ponts de matière entourant ces brèches.

5. Refroidisseur selon une des revendications précédentes, **caractérisé en ce que** les brèches (21a, 21b) sont respectivement entourées de ponts de matière qui se ramifient ou passent de l'un dans l'autre à la manière d'un réseau et qui forment autour de chaque brèche (21, 21a, 21b) une structure polygonale ou annulaire.

6. Refroidisseur selon une des revendications précédentes, **caractérisé en ce que** les ponts de matière (24) forment une structure annulaire de forme hexagonale autour de chaque brèche (21a, 21b), dans lequel de préférence au moins trois sommets de la structure annulaire qui forment un triangle, de préférence un triangle équilatéral, sont agrandis en surface ou encore configurés comme des îlots (25), dans lequel de préférence tous les sommets de la structure polygonale ou annulaire sont agrandis en surface ou encore configurés comme des îlots (25).

7. Refroidisseur selon une des revendications 6 - 8, **caractérisé en ce que** les colonnes (22) continues sont formées par des sommets de la structure annulaire.

8. Refroidisseur selon une des revendications 6 - 9, **caractérisé en ce que** dans des structures annulaires hexagonales, deux cotés du polygone de chaque structure annulaire qui sont disposés de manière opposée et parallèle l'un à l'autre sont orientés dans une première direction d'axe (axe X) et **en ce qu'**avec une structuration identique ou essentiellement identique de la région en forme de crible (20a', 20a" ; 20b - 20b") des couches de refroidisseur (4a', 4a" ; 4b - 4b") voisines les unes des autres dans le refroidisseur, les régions structurées sont prévues de manière respectivement décalée de la longueur d'un côté de polygone dans la première direction d'axe (axe X).

9. Refroidisseur selon une des revendications précédentes, **caractérisé en ce que** les couches de refroidisseur sont configurées de manière identique et chaque couche de refroidisseur est voisine d'une autre couche de refroidisseur retoumée ou renversée dans le refroidisseur.

10. Refroidisseur selon une des revendications précédentes, **caractérisé en ce que** la région structurée (20c', 20c") de chaque couche de refroidisseur (4c', 4c") présente une pluralité de brèches (21c) configurées par exemple en forme d'équerre qui sont formées respectivement par deux sections d'ouverture (26, 27) se croisant ou se coupant, et **en ce que** des couches de refroidisseur (4c', 4c") voisines se raccordent l'une à l'autre de telle manière que les brèches (21c) de couches de refroidisseur voisines ne se recouvrent respectivement que dans une région partielle, des sections ou des ponts de matière formés entre des brèches (21c) voisines d'une couche de refroidisseur soient opposées à une brèche de la couche de refroidisseur voisine et des sections de matière (32) restant entre les brèches (21c) forment les colonnes (22) continues, dans lequel de préférence chaque brèche (21) présente une première section d'ouverture (26) et une deuxième section d'ouverture (27) coupant celle-ci ou passant dans celle-ci et les premières sections d'ouverture (26) d'une pluralité de brèches (21c) sont respectivement prévues à la suite l'une de l'autre sur une première ligne d'axe ou encore diagonale (D26) commune et séparées les unes des autres: par des ponts de matière (29) et les deuxièmes sections d'ouverture (27) d'une pluralité de brèches (21 c) sont respectivement prévues à la suite l'une de l'autre sur une deuxième ligne d'axe ou encore diagonale (D27) commune et séparées les unes des autres par des ponts de matière (30).

11. Refroidisseur selon la revendication 10, **caractérisé en ce que** les diagonales (D26, D27) se coupent à un angle, de préférence à un angle égal ou inférieur à 90°, et/ ou **en ce que** les brèches (21c) ou encore leurs diagonales (D26, D27) forment un angle qui, dans le cas de couches de refroidisseurs (4c - 4c") voisines les unes des autres, s'ouvre en direction de côtés opposés.

12. Refroidisseur selon une des revendications précédentes, **caractérisé en ce que** les brèches de couches de refroidisseur voisines se recouvrent respectivement au niveau de régions terminales des sections d'ouverture (26, 27) qui sont éloignées de la région dans laquelle les sections passent de l'une dans l'autre ou encore se coupent l'une l'autre.

13. Refroidisseur selon une des revendications précédentes, **caractérisé en ce qu'**au moins une partie des couches de refroidisseur est constituée de métal ou d'une feuille de métal, par exemple en cuivre, et / ou **en ce que** les couches de refroidisseur (4) sont reliées ensemble en utilisant la technique DCB ou par des jonctions par diffusion.

14. Refroidisseur selon une des revendications précédentes, **caractérisé en ce qu'**il est pourvu sur son côté supérieur et/ou sur son côté inférieur d'au moins une couche (14, 19) en céramique.

15. Refroidisseur selon une des revendications précédentes, **caractérisé en ce que** des composants électriques (16) sont prévus sur au moins un côté du refroidisseur.

16. Refroidisseur selon une des revendications précédentes, **caractérisé en ce que** la couche de céramique est pourvue d'une métallisation (15), de préférence d'une métallisation (15) formant des bandes de guidage, des surfaces de contact, des surfaces de fixation, etc.

17. Refroidisseur selon une des revendications précédentes, **caractérisé en ce qu'**au moins deux refroidisseurs individuels (33, 34) sont reliés ensemble en cascade pour former un refroidisseur global (1d), une couche de séparation (36) étant de préférence prévue entre les refroidisseurs.

18. Refroidisseur selon une des revendications précédentes, **caractérisé en ce qu'**un liquide, par exemple de l'eau, de l'huile est utilisé comme agent réfrigérant.

19. Refroidisseur selon une des revendications précédentes, **caractérisé par** sa configuration comme refroidisseur par évaporation.

20. Refroidisseur selon une des revendications précédentes, **caractérisé en ce que** chaque brèche (21, 21a, 21b; 21c) dans une couche de refroidisseur (4, 4a', 4a" ; 4b, 4b", 4c', 4c") recouvre au moins en partie au moins deux brèches (21, 21a, 21b, 21c) dans une couche réfrigérante voisine et / ou **en ce que** les brèches (21, 21a; 21b, 21c) de chaque deuxième couche de refroidisseur (4, 4a', 4a" ; 4b; 4b", 4c', 4c") sont disposées de manière à coïncider.

21. Circuit électrique comprenant au moins un composant électrique ou électronique (16) et un refroidisseur comme dissipateur de chaleur pour le composant (16), **caractérisé par** la configuration du refroidisseur selon une des revendications 1 - 20.
